# EUROPÄISCHE PATENTSCHRIFT

(11) **EP 2 185 856 B1**
(45) Veröffentlichungstag und Bekanntmachung des Hinweises auf die Patenterteilung: **19.10.2011**
(21) Anmeldenummer: 08803116.6
(22) Anmeldetag: 20.08.2008
(51) Int. Cl.: F21K 99/00, H05B 33/08, F21Y 101/02

(54) **BELEUCHTUNGSEINRICHTUNG MIT MEHREREN STEUERBAREN LEUCHTDIODEN**
LIGHTING DEVICE COMPRISING A PLURALITY OF CONTROLLABLE LIGHT DIODES
DISPOSITIF D'ECLAIRAGE COMPRENANT PLUSIEURS DIODES ELECTROLUMINESCENTES COMMANDABLES

(30) Priorität: 07.09.2007 DE 102007044567
(43) Veröffentlichungstag der Anmeldung: 19.05.2010
(73) Patentinhaber: Arnold & Richter Cine Technik GmbH & Co. Betriebs KG, 80799 München (DE)
(72) Erfinder: MELZNER, Erwin, 83112 Frasdorf (DE); KRÄMER, Regine, 81825 München (DE); HAUBMANN, Michael, A-1230 Wien (AT); HOCHREITER, Johann, A-3040 Neulengbach (AT)
(74) Vertreter: Ninnemann, Detlef
(86) Internationale Anmeldenummer: PCT/EP2008/060892
(87) Internationale Veröffentlichungsnummer: WO 2009/033922

(56) Entgegenhaltungen:
- WO-A-2006/066530
- WO-A-2006/082537
- WO-A-2006/105649
- WO-A-2006/119750
- WO-A-2007/065390
- WO-A-2007/071397
- DE-U1- 20 309 033
- FR-A- 2 830 314

## Beschreibung

Die Erfindung bezieht sich auf eine Beleuchtungseinrichtung gemäß dem Oberbegriff des Anspruchs 1. Dokument DE 203 09 0 33U offenbart ein Leuchtmodul mit allen Merkmalen eines Moduls der Beleuchtungseinrichtung der Oberbegriff des Anspruchs 1.

Als Leuchtdioden, Licht emittierende Dioden oder LEDs bezeichnete Leuchtmittel bieten die Möglichkeit, flache und über die Fläche homogen Licht abstrahlende Scheinwerfer herzustellen, die in größeren Bauformen als Flächenleuchten mit den Bezeichnungen "Softlight", "Filllight" oder Aufheller in allen Bereichen der professionellen Beleuchtung, als Portrait-Leuchten in unmittelbarer Umgebung einer Laufbild- oder Videokamera, in engen Räumen, wie beispielsweise Fahrzeugen und Treppenhäusern, und zum Aufbau von Leuchtwänden bei der Event- und Bühnenbeleuchtung eingesetzt werden können.

Aus der DE 20 2004 016 637 U1 ist eine Beleuchtungseinrichtung mit einem Träger bekannt, auf dem Anschlussstellen zum Kontaktieren elektronischer Bauteile und Leiterbahnen vorgesehen sind, die die Anschlussstellen untereinander verschalten und mit einer Stromquelle verbinden. Auf dem Träger sind eine Leuchtdiode, eine Ansteuerelektronik und Schaltvorrichtungen zum Schalten der Leuchtdiode angeordnet. Die Leuchtdiode emittiert insbesondere weißes Licht und ist mechanisch auf dem Träger befestigt und elektrisch mit Anschlussstellen kontaktiert. Die Ansteuerelektronik enthält einen Lichtsensor zur Messung der Umgebungshelligkeit und Regelung der Helligkeit der Leuchtdiode und weist zur Steuerung der Intensität, mit der die Leuchtdiode Licht emittiert, eine Pulsweitenmodulationsschaltung auf.

Bei einer Kombination mehrerer derartiger Beleuchtungseinrichtungen ist es erforderlich, die vorgegebene Abstrahlcharakteristik und Ansteuerung jeder einzelnen Beleuchtungseinrichtung bei der Ermittlung der Gesamtcharakteristik der erweiterten Beleuchtungseinrichtung zu berücksichtigen. Darüber hinaus weist die bekannte Beleuchtungseinrichtung durch die Integration mehrerer auf dem Träger angeordneter Ansteuerelektroniken einen erheblichen Platzbedarf auf, was bei einer Zusammenstellung einer Vielzahl von Beleuchtungseinrichtungen zu beispielsweise einem Scheinwerfer zu erheblichen, in der Praxis nicht akzeptablen Abmessungen führen würde und wegen des großen gegenseitigen Abstandes der einzelnen auf dem Träger zusammen mit den Ansteuerelektroniken und Schalteinrichtungen angeordneten Leuchtdioden die Anzahl lichtabgebender Elemente zu gering für einen Scheinwerfer wäre. Daher ist eine Anwendung der bekannten Beleuchtungseinrichtung auf Innenbeleuchtungen von Kraftfahrzeugen, Leuchtspots, Leselampen oder dergleichen beschränkt.

Beleuchtungsscheinwerfer mit lichtemittierenden Dioden bzw. LEDs, die beispielsweise als Kameraaufsatzlicht für Film- und Videokameras eingesetzt werden, weisen entweder die Farbtemperatur "tageslichtweiß" oder "warmweiß" auf, wobei eine stufenlose bzw. exakte Ein- oder Umschaltung von einer warmweißen auf eine tageslichtweiße Farbtemperatur nicht möglich und bei beiden Varianten die Farbwiedergabe bei Film- und Videoaufnahmen unbefriedigend ist.

Beim Einsatz verschiedenfarbiger LEDs mit einem nicht kontinuierlichen Spektralverlauf in einem LED-Scheinwerfer für die Beleuchtung von Film- oder Videoaufnahmen erreichen die LEDs zwar die geforderten Werte für Farbtemperatur und Farbwiedergabe, weisen aber dennoch bei der Verwendung für Filmaufnahmen gegenüber Glühlampen- bzw. HMI-Lampen oder Tageslicht einen erheblichen Farbstich auf. Man spricht in diesem Fall von einer ungenügenden Mischlichtfähigkeit.

Aus der EP 0 921 568 A2 ist eine Beleuchtungseinrichtung bekannt, bei der mehrere LED-Chips, die monochromatisches Licht unterschiedlicher Farbe abgeben, in Vertiefungen eines dreidimensionalen Trägers mit rechteckigem Querschnitt eingesetzt, elektrisch mit Leiterbahnen verbunden und mit einem transparenten Kunststoff versiegelt werden. In Abstrahlrichtung der LED-Chips ist eine aus Mikrolinsen zur Lichtsteuerung bestehende Diffusorplatte aus transparentem Kunststoff mit dem dreidimensionalen Träger verbunden. Die matrixförmige Kombination mehrerer in den Vertiefungen des Trägers angeordneter Module mit LEDs, die monochromatisches rotes, grünes, blaues und gelbes Licht bei unterschiedlicher Farbmischung und Lichtstreuung abstrahlen, führt zu einer Beleuchtungseinrichtung mit einstellbarer Lichtfarbe und Lichtstreuung.

Auch bei dieser matrixförmig aufgebauten Beleuchtungseinrichtung wird die Gesamtcharakteristik des von der Beleuchtungseinrichtung abgestrahlten Lichts von den einzelnen, in der Vertiefungen des dreidimensionalen Trägers angeordneten Lichtmodulen bestimmt, das heißt bei einer Veränderung einzelner Module muss die Gesamtcharakteristik der Beleuchtungseinrichtung neu ermittelt werden. Da den einzelnen Modulen der Beleuchtungseinrichtung individuelle Eigenschaften bezüglich der Farbcharakteristik und Lichtstreuung zugewiesen sind, kann beim Ausfall einzelner Module die Gesamtcharakteristik des von der Beleuchtungseinrichtung abgegebenen Lichts erheblich verändert werden.

Aufgabe der vorliegenden Erfindung ist es, eine Beleuchtungseinrichtung der eingangs genannten Art anzugeben, die Licht mit einstellbarer Farb-, Helligkeits- und Strahlungscharakteristik abgibt, kompakt aufgebaut ist, einen autarken Betrieb ermöglicht und mit gleichartigen Beleuchtungseinrichtungen beliebig konfigurierbar ist und ein Beleuchtungsgerät, insbesondere einen Scheinwerfer oder eine Flächenleuchte bzw. Lichtpanel, mit im Wesentlichen homogener, steuerbarer Lichtabgabe gewährleistet.

Diese Aufgabe wird erfindungsgemäß durch die Merkmale des Anspruchs 1 gelöst.

Die erfindungsgemäße Lösung stellt eine Beleuchtungseinrichtung bereit, die Licht mit einstellbarer Farb-, Helligkeits- und Strahlungscharakteristik abgibt, kompakt aufgebaut ist, einen autarken Betrieb ermöglicht und auf Grund ihrer Modularität mit gleichartigen Beleuchtungseinrichtungen beliebig konfigurierbar ist und ein Beleuchtungsgerät, insbesondere einen Scheinwerfer oder eine Flächenleuchte bzw. Lichtpanel, mit im Wesentlichen homogener, steuerbarer Lichtabgabe gewährleistet. Dabei wird durch Auswahl der Licht unterschiedlicher Wellenlänge abgebenden LEDs und deren Anordnung sowie Ansteuerung eine einstellbare Lichtmischung bei optimalem Farbraum und, im Falle von weißem Licht, mit optimaler Farbwiedergabe ermöglicht.

Die Beleuchtungseinrichtung besteht im Wesentlichen aus einem Leuchtmodul, in das sowohl eine Lichtquelle mit mehreren Licht unterschiedlicher Wellenlänge abgebenden LEDs und eine Modulelektronik zur Ansteuerung der LEDs der Lichtquelle integriert sind, wobei die Modulelektronik und die LEDs mit einem Modulträger des Leuchtmoduls verbunden sind. Durch eine Erweiterung des Leuchtmoduls mit einem oder mehreren Temperatur- und/oder Farbsensoren, die zusammen mit den LEDs in kompakter Form auf einer mit dem Modulträger verbundenen Platine angeordnet sind, ist eine autarke elektrische Ansteuerung und Regelung der Lichtquelle mittels der einen Microcontroller aufweisenden Modulelektronik möglich.

In weiterer Ausgestaltung kann eine Optik zur Lichtmischung und/oder Strahlformung an das Leuchtmodul angekoppelt werden. Durch die Anordnung einer Vielzahl von Leuchtmodulen, deren Modulelektronik mit einer übergeordneten Steuer- oder Regeleinrichtung verbunden wird, kann eine steuer- und regelbare Lichtquelle für ein Beleuchtungsgerät hergestellt werden, die mit weiteren optischen Einrichtungen zur Strahlformung verbunden werden kann.

Durch Auswahl und Zusammensetzung der Licht unterschiedlicher Wellenlänge abgebenden LEDs und deren Anordnung auf der Platine der Lichtquelle sowie durch eine entsprechende Ansteuerung der LEDs durch die Modulelektronik kann das Leuchtmodul eine Lichtmischung abgeben, deren Parameter wie Lichtfarbe, Farbtemperatur und Farbart neben der Helligkeit des vom Leuchtmodul abgegebenen Lichts einstellbar sind.

Im Wesentlichen wird dabei unterschieden zwischen einem bezüglich der Farbwiedergabe optimierten Betriebsmodus, in dem hauptsächlich weißes Licht mit sehr guter Farbwiedergabe für Beleuchtungszwecke abgestrahlt wird und einem bezüglich der Helligkeit optimierten Betriebsmodus, bei dem vorwiegend farbiges Licht mit großer Lichtstärke für Zwecke der Studio, Theater- und Effektbeleuchtung abgestrahlt wird. Durch eine entsprechende Programmierung des Leuchtmoduls und der übergeordneten Steuer- und Regeleinrichtung bzw. der Elektronik- und Softwaremodule kann diese Auswahlmöglichkeit dem Anwender zugänglich gemacht werden.

Der modulare Aufbau und die Zusammensetzung des Leuchtmoduls ermöglicht die Bildung unterschiedlicher Arten und Größen von Beleuchtungsgeräten beispielsweise eines Scheinwerfers oder einer Flächenleuchte.

Mit einer individuellen Ansteuerung von Licht unterschiedlicher Wellenlänge abgebenden LEDs oder Gruppen von jeweils Licht gleicher Wellenlänge abgebenden LEDs durch die Modulelektronik ist eine gezielte und von der Temperatur unabhängige Einstellung der Lichtmischung aus dem von den verschiedenfarbigen LEDs abgegebenen Licht gewährleistet.

Die mit einem Mikrocontroller ausgestattete Modulelektronik ermöglicht es, das Steuerprogramm zur Ansteuerung der LEDs zu variieren oder das Leuchtmodul mit einem übergeordneten, externen, d.h. vom Leuchtmodul getrennten Controller zu verbinden, so dass die Modulelektronik des Leuchtmoduls die gesamte Steuerung und gegebenenfalls Regelung des autarken Leuchtmoduls vornimmt und damit den externen Controller entlastet.

Vorzugsweise steuert die Modulelektronik die LEDs in Abhängigkeit von der Temperatur und/oder der Leistung des Leuchtmoduls und/oder der Helligkeit und/oder der Farbe der von dem Leuchtmodul abgegebenen Lichtmischung derart an, dass die aus den Licht unterschiedlicher Wellenlänge abgebenden LEDs zusammengesetzte Helligkeit, Farbe und Farbart der Lichtmischung konstant ist, was eine lokale Temperaturkompensation und ein autarkes Leuchtmodul ohne die Notwendigkeit oder Inanspruchnahme einer externen Steuer- und Regeleinrichtung ermöglicht.

In weiterer Ausgestaltung der erfindungsgemäßen Lösung sind die Helligkeit und die Farbart der vom Leuchtmodul abgegebenen Lichtmischung durch die Modulelektronik einstellbar bzw. über die Modulelektronik kalibrierbar.

Die Möglichkeit zur präzisen Kalibrierung des Leuchtmoduls bietet den Vorteil, dass die Toleranzen der verwendeten LEDs ausgeglichen werden können bzw. eine höhere Akzeptanz der LED-Toleranzen, ohne dass es notwendig wird, zur Erzielung von sich gleich verhaltenden Leuchtmodulen eine sehr große Anzahl von LED-Selektionen mit geringen Toleranzen zu beschaffen und bereit zu halten.

Um eine optimale Lichtmischung der Licht unterschiedlicher Wellenlänge abgebenden LEDs allein durch die Geometrie der Anordnung der LEDs auf der Platine der Lichtquelle schon in geringer Entfernung vom Leuchtmodul sowie durch die Auswahl der von den LEDs abgegebenen Wellenlängen und den daraus resultierenden Farbmöglichkeiten zu gewährleisten, sind die LEDs auf der Platine der Lichtquelle mit geringem gegenseitigen Abstand angeordnet und über auf der Platine angeordnete Leiterbahnen und elektrische Anschlüsse der Lichtquelle mit der Modulelektronik verbunden, die über elektrische Anschlüsse des Leuchtmoduls mit dem externen Controller verbunden werden kann.

Um unterschiedlich konfigurierte Lichtquellen mit beliebig konfigurierbaren Modulelektroniken zu ermöglichen, wird die Schnittstelle zwischen der Lichtquelle und der Modulelektronik so ausgelegt, dass möglichst alle Anschlüsse der verwendeten LEDs zur Außenseite der Lichtquelle hin geführt sind, wo sie mit einer vorzugsweise den Modulträger bildenden Platine der Modulelektronik verbunden werden. Diese Verbindung geschieht über Lötfahnen, die in einem standardisierten Raster angeordnet sind und/oder über einen Steckverbinder in der Art von mehrpoligen Stiftleisten oder durch eine direkte Draht- oder Bond-Verbindung. Besonders im letztgenannten Fall ist es möglich, dass die Lichtquelle sehr klein, und damit kostengünstig und mit einer hohen Leuchtdichte aufgebaut werden kann.

Durch diese Ausgestaltung der Schnittstellen zwischen der Lichtquelle und der Modulelektronik des Leuchtmoduls ist gewährleistet, dass beispielsweise zur Bereitstellung von Beleuchtungseinrichtungen mit unterschiedlichen Farbcharakteristiken Lichtquellen mit unterschiedlich zusammengesetzten und ausgebildeten LEDs mit einer standardisierten Modulelektronik zur Ansteuerung der LEDs verbunden werden können und eine Regelung der von der Beleuchtungseinrichtung abgegebenen Lichtmischung ermöglicht wird.

Der modulare Aufbau und der autarke Betrieb der Leuchtmodule lässt problemlos dynamische Farb- oder Helligkeitsveränderungen bis hin zum kompletten An- oder Abschalten bestimmter Bereiche der Leuchtfläche oder Spezialeffekte zu, bei denen beispielsweise für eine Portraitbeleuchtung durch Einschalten eines Teilbereichs der Leuchtfläche die Richtung, aus der das Licht abgestrahlt wird, verändert werden kann, oder gezielt Farbsäume erzeugt werden.

Diese modulare Variabilität ermöglicht es, unter Verwendung gleichartiger Leuchtmodule sowohl Flächenleuchten mit großer Licht abstrahlender Oberfläche als auch Scheinwerfer herzustellen, mit denen gebündeltes oder aufgeweitetes Licht abgestrahlt wird. Durch eine stufenlose Änderung der Charakteristik der Beleuchtungseinrichtung kann zwischen "Spotlight" und "Softlight" variiert werden, indem beispielsweise wenige Module in der Mitte der Beleuchtungseinrichtung mit hoher Leistung (Spotlight) oder viele Module mit geringer Leistung (Softlight) betrieben werden.

Dabei müssen die Abstrahlflächen der oben genannten Scheinwerfer nicht rechteckig und plan sein, sondern es kann eine Vielzahl von möglichen Formen gebildet werden, die sich mit den vorwiegend quadratischen Leuchtmodulen realisieren lassen, wie z.B. Lichtstreifen und -balken, L-Formen, Ringe usw. Auch gewölbte Abstrahlflächen, die sich aus einer Anzahl von Leuchtmodulen zusammensetzen, können zur Erzielung bestimmter Effekte gebildet werden. Weiterhin können so genannte "LED-Schlangen" in Form von beweglichen Ketten gebildet werden, die eine beliebige geometrische Form der Aneinanderreihung wie Zick-Zack-Formen, Kreis- oder Ellipsenformen zulassen.

Zur Bildung eines Kompromisses aus guten Isolationseigenschaften zur Sicherung der elektrischen Verbindungen der LEDs mit der Modulelektronik einerseits und größtmöglicher Wärmeleitfähigkeit zur optimalen Nutzung der Leistungsfähigkeit der LEDs andererseits besteht die die LEDs tragende Platine der Lichtquelle aus einer Platine aus einem elektrisch isolierenden, gut Wärme leitenden Werkstoff, vorzugsweise aus Aluminiumnitrit oder einer aus einer Metallkernplatine.

Die Lichtquelle und die Modulelektronik können direkt miteinander verbunden sein, wenn z.B. die Lichtquelle direkt auf die Modulelektronik oder über eine Aussparung in der Modulelektronik aufgelötet oder aufgesteckt ist. In diesem Fall wird ein flacher, platzsparender Aufbau erreicht. Das gesamte Leuchtmodul kann dann z.B. über Schrauben an einem größeren Kühlkörper oder am Scheinwerfergehäuse befestigt werden, wobei es thermisch von Vorteil ist, wenn die Lichterzeugungseinheit unmittelbar an den größeren Kühlkörper angekoppelt ist.

Dem entsprechend kann der Modulträger plattenförmig ausgebildet werden, eine Ausnehmung zum Einsetzen der als Platine ausgebildeten Platine und/oder des Sockels eines Modul-Kühlkörpers und zur Befestigung der Platine und/oder des Modul-Kühlkörpers Befestigungsaufnahmen sowie Verbindungselemente zum Verbinden des Modulträgers mit einem Motherboard aufweisen.

Um die Leistungsfähigkeit der LEDs ohne Beeinträchtigung von deren Lebensdauer optimal nutzen zu können, ist die Platine der Lichtquelle gut wärmeleitend mit einem Modul-Kühlkörper verbunden und vorzugsweise auf einem gegenüber einer Oberfläche des Modul-Kühlkörpers erhöhten Sockel des Modul-Kühlkörpers angeordnet, so dass die Platine gegenüber der Oberfläche des Modulträgers erhöht angeordnet ist, während die den Sockel aufnehmende Oberfläche des Modul-Kühlkörpers Befestigungselemente zur Verbindung des Modul-Kühlkörpers mit dem Modulträger aufweist.

In alternativer Ausführung können die Lichtquelle und die Modulelektronik an einem gemeinsamen Träger-Bauteil, wie z.B. dem Modul-Kühlkörper befestigt sein. Diese Ausführungsform bietet bei gleich guter Wärmeableitung die Vorteile, dass eine sichere und einfache mechanische Verbindung zwischen dem gesamten Leuchtmodul und einem Scheinwerfergehäuse bzw. einer Kühleinrichtung über Norm-Befestigungselemente wie Schrauben, Stifte u. ä. hergestellt werden kann und dass die Platine bzw. der Modulträger der Modulelektronik nicht mechanisch belastet wird. Der Modul-Kühlkörper besteht bevorzugt aus einem sehr gut wärmeleitenden Material wie z.B. Kupfer oder Aluminium.

In bevorzugter Ausführungsform ist die Lichterzeugungseinheit gegenüber der Modulelektronik erhöht angebracht, damit Befestigungselemente, wie z.B. Schrauben oder Kerbnägel, sowie elektronische Bauteile auch auf der Oberseite der Modulelektronik untergebracht werden können, ohne dass sie den Strahlengang der LEDs stören. Eine nachgeschaltete Optik kann auf diese Weise alle Lichtstrahlen, die in den Halbraum abgestrahlt werden auffangen und somit sehr effektiv gestaltet werden.

Der Modulträger ist insbesondere plattenförmig ausgebildet, so dass er gleichzeitig die Platine der Modulelektronik bildet. Vorzugsweise weist er einen Umriss für eine im Wesentlichen lückenlose Aneinanderreihung einer Vielzahl gleichartig ausgebildeter Modulträger und damit Leuchtmodule für eine Licht abgebende Fläche eines Beleuchtungsgerätes auf.

Zur Bildung einer größeren Lichtquelle für ein Beleuchtungsgerät sind die Modulträger mehrerer Leuchtmodule in Aufnahmen eines einen externen Controller enthaltenden Motherboards einsetzbar.

In einer bevorzugten Ausführungsform besteht die Modulelektronik aus einer Stromversorgungsschaltung, einer Digital-Elektronik mit einem Mikrocontroller und einer Anzahl von gleichartigen Treiberschaltungen für die verschiedenen Farbkanäle, so dass durch den Einsatz mehrerer gleichartig aufgebauter Treiberschaltungen zur Ansteuerung einzelner LEDs oder zur gleichzeitigen Ansteuerung mehrerer, jeweils Licht gleicher Wellenlänge abgebender LEDs auch ein modularer Aufbau der Modulelektronik selbst gewährleistet ist. Dabei sind die Treiberschaltungen an jeweils einen pulsweitenmodulierte Steuersignale abgebenden Ausgang des Mikrocontrollers angeschlossen und mit einer Versorgungsspannung beaufschlagt..

Um den wegen der Herstellungstechnologie unterschiedlichen Chip-Familien der LEDs Rechnung zu tragen und die Verlustleistungen der Leuchtmodule gering zu halten, sind mehrere Versorgungsspannungen vorgesehen, die einzelnen oder gruppenweise zusammengefassten Treiberschaltungen zugeordnet werden. Dem entsprechend wird nach einem weiteren Merkmal der Erfindung die Modulelektronik mit einer oder mehreren Betriebsspannungen versorgt und erzeugt, stabilisiert und begrenzt die benötigen LED-Ströme selbst.

Die Treiberschaltungen weisen eine temperaturkompensierte Konstantstromquelle auf, die an eine der Treiberschaltung zugeordnete Versorgungsspannung angeschlossen ist und einen in Reihe zu den von der jeweiligen Treiberschaltung gespeisten LEDs geschalteten elektronische Schalter derart ansteuert, dass die LEDs mit konstantem Strom gespeist werden.

Eine digitale, serielle Schnittstelle zum Microcontroller erlaubt im Wesentlichen die Ansteuerung der Farbkanäle, die Kalibrierung, das Abfragen von Statusinformationen vom Leuchtmodul, wie z.B. der Board-Temperatur, und das Überladen des Betriebsprogramms (Download). Die Schnittstelle zum Leuchtmodul ist vorzugsweise netzwerkfähig und in der Art eines industriellen Feldbusses ausgelegt, damit auch eine größere Anzahl von Leuchtmodulen an einem Bus betrieben werden kann.

Insbesondere bei der Verbindung mehrerer gleichartig aufgebauter Leuchtmodule einer Beleuchtungseinrichtung ist die Modulelektronik in der Lage, Daten über eine serielle Schnittstelle mit einem externen Controller auszutauschen und die LEDs über vorzugsweise pulsweitenmodulierte Signale zur stufenlosen Ansteuerung der LEDs anzusteuern.

Werden mehrere Leuchtmodule zu einem größeren Scheinwerfer zusammengefasst, dann besteht die Möglichkeit, dass unterschiedliche Teile des Scheinwerfers unterschiedlich erwärmt werden. Das geschieht z.B. durch externe Aufheizung durch die Sonne oder durch einen anderen, in der Nähe stehenden Scheinwerfer, oder durch Konvektion innerhalb des Scheinwerfers selbst, wo die warme Luft nach oben steigt. Diese Effekte hätten zur Folge, dass die Leuchtmodule auf Grund der Eigenschaften der LEDs unterschiedlich hell abstrahlen. Der Scheinwerfer wäre also über die Abstrahlfläche nicht mehr gleichmäßig hell, sondern es würde sich ein Gradient in Richtung der kühlsten Stelle ergeben. Die Ausgestaltung der Leuchtmodule mit einem Microcontroller und einer digitalen Schnittstelle erlaubt es aber, dass die Leuchtmodule ihre Board-Temperatur messen und an andere Bus-Teilnehmer übertragen können. Ein zentrales Master-Modul oder ein externer Controller können daher mit diesen Daten dem oben genannten Effekt entgegenwirken, in dem sie die Leuchtmodule so ansteuern, dass wieder eine gleichmäßige Helligkeit über die Abstrahlfläche entsteht.

Bei einer aus mehreren gleichartig aufgebauten Leuchtmodulen zusammengesetzten Beleuchtungseinrichtung führt das Master-Modul oder der externe Controller eine periodische Abfrage aller Platinentemperaturen des Leuchtmoduls durch und gibt ein die höchste ermittelte Temperatur repräsentierendes Signal an alle Leuchtmodule ab, die nach einem Synchronisationsbefehl eine Helligkeitsanpassung auf der Grundlage des der höchsten ermittelten Temperatur repräsentierenden Signals durchführen.

Eine gleichwertige Kompensation der oben genannten Effekte kann erreicht werden, wenn die Leuchtmodule, mit einem Helligkeitssensor und/oder Farbsensor ausgestattet sind, dessen Signale ausgewertet und übertragen werden können. Die Korrektur geschieht in diesem Fall direkt über die Helligkeit bzw. Farbe und nicht über die Board-Temperatur.

Durch die Zusammensetzung der Lichterzeugungseinheit aus Licht unterschiedlicher Wellenlänge abgebenden LEDs kann ohne Hardwareveränderung allein durch die Ansteuerung der LEDs mittels der Modulelektronik eine gewünschte Lichtmischung eingestellt und gegebenenfalls kompensiert bzw. unter Einbeziehung eines Helligkeitsund/oder Farbsensors autark geregelt werden.

Vorzugsweise sind die LEDs als LED-Chips ausgebildet, die in Chip-on-Board-Technologie mit den Leiterbahnen der Platine vorzugsweise durch Bondung, Flip-chip-Kontaktierung oder Leitklebung elektrisch kontaktiert sind.

Durch die Ausbildung der LEDs als LED-Chips, die vorzugsweise durch Bondung mit der Platine verbunden werden, ist eine einfache Herstellung und Integration der LEDs in das Leuchtmodul bei einfacher Kontaktierung mit vorhandenen Leiterbahnen und am Rand der Platine einer Lichtquelle vorgesehenen Anschlüssen gewährleistet und die Voraussetzung für beispielsweise eine automatische Bestückung der Platine der Lichtquelle mit Licht unterschiedlicher Wellenlänge abgebenden LEDs gegeben.

Zur Bereitstellung unterschiedlicher Helligkeiten, Lichtcharakteristiken und Farbräume unter Berücksichtigung einer optimalen Licht- und Farbmischung ist eine unterschiedliche Konfiguration der LEDs auf der Platine der Lichtquelle möglich. So kann bzw. können
- in der Mitte der Platine mindestens ein weißes Licht abgebender LED-Chip und um diesen in rotationssymmetrischer Anordnung, in gleichen Winkelabständen und auf konzentrischen Kreisen um die Mitte der Platine mehrere farbiges und/oder weißes Licht abgebende LED-Chips angeordnet werden,
- eine Anzahl von n LED-Chips vorgesehen ist, von denen n/3 weißes oder warmweißes Licht abgebende LEDs und jeweils n/6 rotes, blaues, grünes und gelbes beziehungsweise amberfarbenes Licht abgebende LEDs sind, insbesondere können vier LED-Chips ein inneres Quadrat bilden und acht weitere LED-Chips konzentrisch auf einem Kreis um die Mitte des inneren Quadrats oder paarweise auf den Seiten eines konzentrisch zum inneren Quadrat liegenden äußeren Quadrats angeordnet sind, wobei entweder
- vier weißes oder warmweißes Licht abgebende LED-Chips das innere Quadrat bilden und jeweils zwei rotes, blaues, grünes und gelbes beziehungsweise amberfarbenes Licht abgebende LED-Chips konzentrisch und um jeweils 180° gegeneinander und um 45° gegenüber den benachbarten LED-Chips versetzt auf einem Kreis um die Mitte des inneren Quadrats angeordnet sind, oder
- vier farbiges Licht abgebende LED-Chips das innere Quadrat bilden und jeweils ein weißes oder warmweißes Licht abgebender LED-Chip mit einem farbiges Licht abgebenden LED-Chip paarweise auf den Seiten eines konzentrisch zum inneren Quadrat liegenden äußeren Quadrats angeordnet sind.

In sämtlichen Ausführungsvarianten ist eine enge Anordnung und Platzierung der LEDs eines Leuchtmoduls auf der Platine möglich und eine optimale Lichtmischung der verschiedenfarbigen LEDs gewährleistet.

Eine weitere vorteilhafte Ausgestaltung der erfindungsgemäßen Beleuchtungseinrichtung ist **dadurch gekennzeichnet, dass** zumindest die auf der Platine angeordneten LEDs der Lichtquelle mit einer lichtdurchlässigen Vergussmasse überzogen sind.

Die lichtdurchlässige Vergussmasse dient sowohl als mechanischer Schutz für die Bondung der LEDs und die Leiterbahnen zu den rasterförmig angeordneten Anschlüssen der Lichtquelle als auch als Schutz gegen eine Verschmutzung der Lichtquelle.

Zur Gewährleistung eines kompakten Aufbaus des Leuchtmoduls sowie zur Vereinfachung und Verbilligung der Herstellung des Leuchtmoduls kann in weiterer Ausgestaltung die Vergussmasse optisch aktiv ausgebildet sein, so dass beispielsweise der Brechungsindex der Vergussmasse gezielt genutzt wird, um eine in Abstrahlrichtung nachgeordnete Optik besser einsetzen, d. h., die von der Lichtquelle abgegebenen Lichtstrahlen für die nachgeordnete Optik des Leuchtmoduls besser einkoppeln zu können.

Eine weitere Ausgestaltung der Lichtquelle ist **dadurch gekennzeichnet, dass** ein vorzugsweise aus Kunststoff bestehender Ring um die LEDs angeordnet, zur optimalen Lichtreflexion auf der Innenseite weiß oder verspiegelt ist und beispielsweise über eine Klebeverbindung mit der Oberfläche der Platine verbunden wird, wobei der Ring insbesondere aus Kunststoff besteht, und einen definierten Abstand zu den äußeren LEDs sowie eine vorgegebene Höhe aufweist.

Die Anordnung eines Rings insbesondere aus Kunststoff um die LEDs der Lichtquelle dient als definierter Abstandshalter zum Anflanschen einer nachgeordneten Optik des Leuchtmoduls und in der Ausgestaltung, dass der Innenraum des Rings mit der lichtdurchlässigen Vergussmasse ausgefüllt ist, als Begrenzung der Vergussmasse sowie zu deren erleichtertem Aufbringen auf die LEDs der Lichtquelle.

In weiterer Ausgestaltung der Lichtquelle ist der Ring zylinderförmig oder oval ausgebildet und zur Gewährleistung optimaler Reflexionseigenschaften innen weiß oder verspiegelt.

An das Leuchtmodul beziehungsweise an mehrere zu einer Leuchtmodulgruppe zusammengefasste Leuchtmodule kann eine Optik angekoppelt werden.

Zur Optimierung des Wirkungsgrades des von der Beleuchtungseinrichtung abgestrahlten Lichts, zur Erzielung maximaler Helligkeit der von den LEDs der Lichtquellen abgestrahlten Lichts sowie zur Aufbereitung des abgestrahlten Lichts für eine weitere optische Beeinflussung des vom Leuchtmodul abgestrahlten Lichts ist in einer ersten Ausführungsform die Lichtquelle mit einer Primäroptik verbunden, die die von den LEDs abgegebenen Lichtstrahlen bündelt bzw. "einsammelt". Dabei bestehen zumindest Teile der Primäroptik aus Polymethylacrylat (PMMA) oder Polycarbobat (PC). Diese Primäroptik kann sowohl zusätzlich als auch alternativ zu einer optisch wirksamen Vergussmasse vorgesehen werden.

Mit der Primäroptik können z.B. breit abstrahlende "Softlights", die eine homogene Abstrahlfläche besitzen, als auch eng abstrahlende "Spotlights", die eine entfernte Fläche homogen beleuchten, als auch Mischformen dieser beiden Scheinwerfertypen mit dem erfindungsgemäßen Leuchtmodul realisiert werden.

Zur weiteren Behandlung der von der Licht sammelnden Optik abgegebenen Lichtstrahlen kann die Primäroptik eine optische Baugruppe zur Licht- und/oder Farbmischung enthalten, welche die gewünschte Abstrahlcharakteristik erzeugt. Diese Baugruppe besteht vorzugsweise aus einem sog. Wabenkondensor, welche mittels einer präzise konstruierten Anordnung von Mikrolinsen die von der ersten Optik ankommenden Lichtstrahlen durchmischt und wieder abstrahlt.

Eine der Primäroptik nachgeschaltete Sekundäroptik dient zur weiteren Strahlformung, kann aber auch zur (zusätzlichen) Licht- und/oder Farbmischung eingesetzt werden. Sie besteht vorzugsweise aus einer Linse, einem Linsenarray oder einem Mikrolinsenarray und weitet den Strahlengang weiter auf, so dass ein größerer Streuwinkel und/oder eine andere Beleuchtungsstärkeverteilung entsteht. Durch Kombination einer vorzugsweise fest angebrachten Primäroptik mit einer Anzahl von verschiedenen Sekundäroptiken kann ein modulares System geschaffen werden, welches dem Anwender eine Anzahl von gewünschten Lichtverteilungen zur Verfügung stellt. Insbesondere kann die Sekundäroptik
- als Projektionsoptik mit engem Halbstreuwinkel ausgebildet werden,
- eine Spot-Optik mit homogener Ausleuchtung und engem Halbstreuwinkel bei hoher Effizienz ergeben,
- aus einer Soft-Optik mit homogener Ausleuchtung und großem Halbstreuwinkel bei hoher Effizienz bestehen.

In einer besonderen Ausführungsform besteht die Sekundäroptik aus einer Zoom-Optik, die zwei gegeneinander in Abstrahlrichtung des Leuchtmoduls motorisch, pneumatisch oder hydraulisch verstellbare Mikrolinsenplatten zum Fokussieren, d.h. zum Aufweiten oder Zusammenfassen der von den LEDs abgegebenen Lichtstrahlen enthält. Damit ist es möglich, eine Beleuchtungseinrichtung zu erzeugen, die in der Bedienung weitgehend beispielsweise einem herkömmlichen Studio- oder Filmscheinwerfer entspricht und der einen dynamisch veränderbaren Halbstreuwinkel von z.B. ca. 20° - 60° aufweist.

Zur Vereinfachung der Fertigung des so mit einer Primäroptik und/oder einer Sekundäroptik ausgestatteten Leuchtmoduls kann die Primäroptik und/oder die Sekundäroptik an dem Ring der Lichtquelle angeflanscht werden.

Wenn die Abstrahlcharakteristik des Leuchtmoduls oder des aus Leuchtmodulen bestehenden Scheinwerfers weiter und ggf. dynamisch verändert werden soll, dann kann eine Tertiäroptik oder ein anderes Licht beeinflussendes Element nachgeschaltet werden. Die Tertiäroptik betrifft handelsübliche Zusatzgeräte, die im Wesntlichen zur Abschattung von Streulicht und zum Weichzeichnen vorgesehen werden wie beispielsweise Diffusoren, Streuscheiben, Flügeltore, Richtgitter und holografische Streufolien.

Zur funktionellen Erweiterung des Leuchtmoduls oder einer aus mehreren gleichartig aufgebauten Leuchtmodulen zusammengesetzten Beleuchtungseinrichtung kann die Lichtquelle und/oder die Primäroptik und/oder die Sekundäroptik mit einer Einrichtung zur Lichtauskopplung, insbesondere mit einem Lichtleiter oder mit einem Spiegel- oder Prismensystem, verbunden werden.

Eine autark ausgebildete Modulelektronik, die mit mindestens einem auf dem Trägerelement angeordneten Sensor, vorzugsweise mit einem Helligkeits-, Temperaturund/oder Farbsensor, verbunden ist, ermöglicht einen selbsttätigen Betrieb des Leuchtmoduls bzw. einer aus mehreren Leuchtmodulen zusammengesetzten Beleuchtungseinrichtung ohne externe Steuerung, wobei die Möglichkeit erhalten bleibt, die vorgegebenen und eingestellten Licht- und Farbcharakteristiken des Leuchtmoduls bzw. der Beleuchtungseinrichtung unter anderem unabhängig von der Temperatur konstant zu halten.

Anhand mehrerer in der Zeichnung dargestellter Ausführungsbeispiele werden weitere Merkmale und Vorteile der Erfindung erläutert. Es zeigen:
- Fig. 1: eine schematische Explosionsdarstellung eines Leuchtmoduls mit einem Modulträger mit integrierter Lichtquelle und Modulelektronik;
- Fig. 2: eine schematische Blockbilddarstellung mehrerer mit einer Primäroptik verbundener Leuchtmodule und einer für die Gruppe von Leuchtmodulen gemeinsamen Sekundär- und Tertiäroptik;
- Fig. 3: eine perspektivische Darstellung eines Basis-Leuchtmoduls mit einer auf einer Trägerplatte angeordneten Lichtquelle und einer Modulelektronik;

- Fig. 4: eine Draufsicht auf die Lichtquelle mit zehn LEDs, einem Temperatursen- sor und rasterförmig angeordneten elektrischen Kontakten;
- Fig. 5: eine Darstellung des Schaltplans der Lichtquelle gemäß Fig. 4;
- Fig. 6: eine Draufsicht auf das Layout der in Fig. 4 dargestellten Lichtquelle;
- Fig. 7: ein Blockschaltbild einer Modulelektronik mit gleichartig aufgebauten Trei- berschaltungen;
- Fig. 8: eine Draufsicht auf eine Lichtquelle mit alternativer Anordnung von LEDs;
- Fig. 9: eine perspektivische Darstellung eines für die Aneinanderreihung gleich- artiger Leuchtmodule geeigneten Basis-Leuchtmoduls;
- Fig. 10: eine perspektivische Darstellung einer weiteren Ausführungsform einer auf einer Aluminiumnitrid-Keramikplatine angeordneten Lichtquelle mit in- tegriertem Temperatursensor;
- Fig. 11: eine perspektivische Darstellung der auf einem Modul-Kühlkörper mit er- höhtem Sockel angeordneten Lichtquelle gemäß Fig. 10;
- Fig. 12: eine perspektivische Darstellung eines Leuchtmoduls mit einem als Plati- ne ausgebildeten Modulträger mit einer Ausnehmung, in die ein die Licht- quelle gemäß Fig. 10 tragender Sockel eines Modul-Kühlkörpers einge- setzt ist;
- Fig. 13: eine perspektivische Ansicht der Unterseite des Leuchtmoduls gemäß Fig. 12;
- Fig. 14: eine Draufsicht auf eine Platine eines LED-Panels für ein LED- Beleuchtungssystem ohne Bestückung mit elektronischen Bauteilen des LED-Panels und ohne Leuchtmodule;
- Fig. 15: eine isometrische Ansicht der mit acht Leuchtmodulen und elektronischen Bauteilen des LED-Panels bestückten Platine gemäß Fig. 14 von der O- berseite;
- Fig. 16: eine Ansicht der Platine des LED-Panels gemäß Fig. 15 von der Untersei- te mit Bestückung und acht in die Ausnehmungen eingesetzten Leucht- module;
- Fig. 17: eine schematische Darstellung der Verbindung der Modulelektronik meh- rerer Leuchtmodule mit einem externen Controller;
- Fig. 18: eine isometrische Ansicht eines LED-Panels mit acht Leuchtmodulen oh- ne optische Einrichtung für ein Beleuchtungssystem und
- Fig. 19: ein schematisches Übersichtsdiagramm eines Beleuchtungssystems mit einem LED-Panel und mehreren LED-Panels.

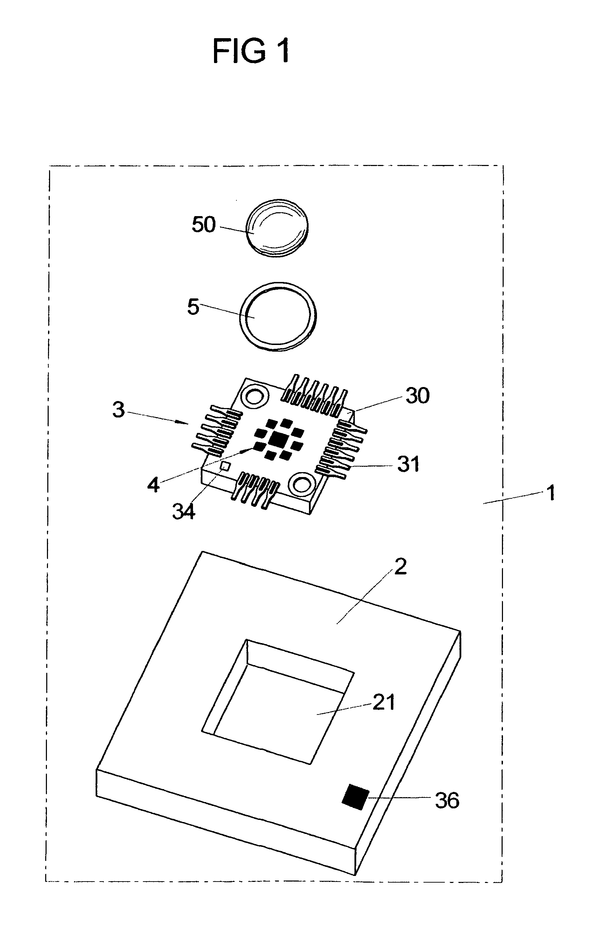

Fig. 1 zeigt in einer schematischen Explosionsdarstellung ein Leuchtmodul 1, das einzeln oder mit mehreren identisch oder gleichartig aufgebauten Leuchtmodulen in einer Beleuchtungseinrichtung wie beispielsweise einem Scheinwerfer, einer Flächenleuchte oder dergleichen eingesetzt wird.

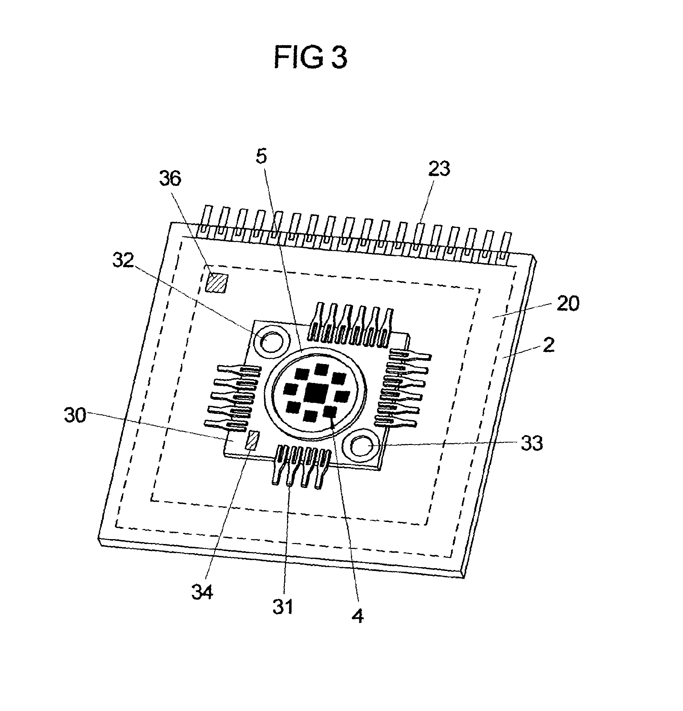

Das Leuchtmodul 1 setzt sich in einer Grundform aus einem als Leiterplatte ausgebildeten Modulträger 2 mit einer darauf angeordneten Modulelektronik 20 und einer Lichtquelle 3 zusammen, die aus einer Platine 30 mit mehreren auf der Platine 30 angeordneten Leuchtdioden (LEDs) 4, einem ebenfalls auf der Platine 30 angeordneten Temperatursensor 34 und am Rand der Platine 30 angeordneten, als Lötfahnen ausgebildeten Kontakten 31 besteht, die mit den LEDs 4 und der Modulelektronik 20 verbunden sind. Eine detaillierte Beschreibung der Lichtquelle 3 erfolgt nachstehend anhand der vergrößerten Darstellung der Lichtquelle 3 in Fig. 3.

Die LEDs 4 setzen sich aus mehreren LEDs zusammen, die Licht unterschiedlicher Wellenlänge, d.h. unterschiedlicher Farbe abgeben, wobei mehrer LEDs auch dieselbe Wellenlänge, d.h. Licht derselben Farbe abstrahlen können. Durch enges Anordnen der LEDs 4 auf der Platine 30 wird bereits eine durch die Auswahl der LEDs einstellbare Lichtmischung aus den unterschiedlichen Farben erzeugt, die durch zusätzliche Maßnahmen wie optische Lichtbündelung und Lichtmischung noch optimiert und durch weitere Steuerungs- und Regelungsmaßnahmen unabhängig von beispielsweise der Temperatur konstant gehalten werden kann, um eine gewünschte Farbtemperatur, Helligkeit und dergleichen einstellen zu können.

Die Lichtquelle 3 wird zur Platz sparenden Anordnung und Erweiterung der Modularität des Leuchtmoduls 1 in eine Aussparung 21 des Modulträgers 2 eingesetzt, so dass die Konfiguration der Lichtquelle 3 unabhängig von der Konfiguration des Modulträgers 2 bzw. der Modulelektronik 20 erfolgen kann, wenn sichergestellt ist, dass die Schnittstellen zwischen der Lichtquelle 3 und der Modulelektronik 20 entsprechend ausgelegt sind.

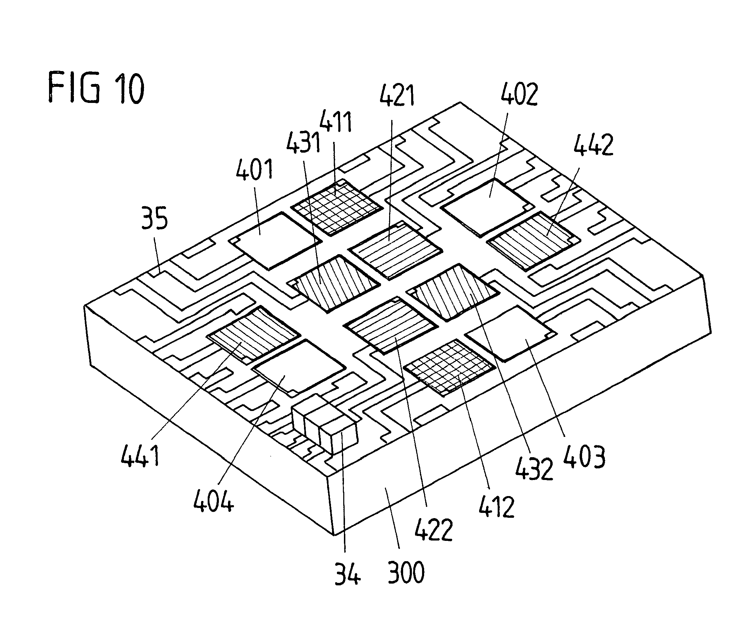

Alternativ kann die Lichtquelle 3 bzw. die Platine 30 entsprechend der in den Fig. 10 bis 13 dargestellten Ausführungsform auf dem Sockel eines Kühlkörpers angeordnet und dieser durch die Aussparung 21 des Modulträgers 2 gesteckt werden.

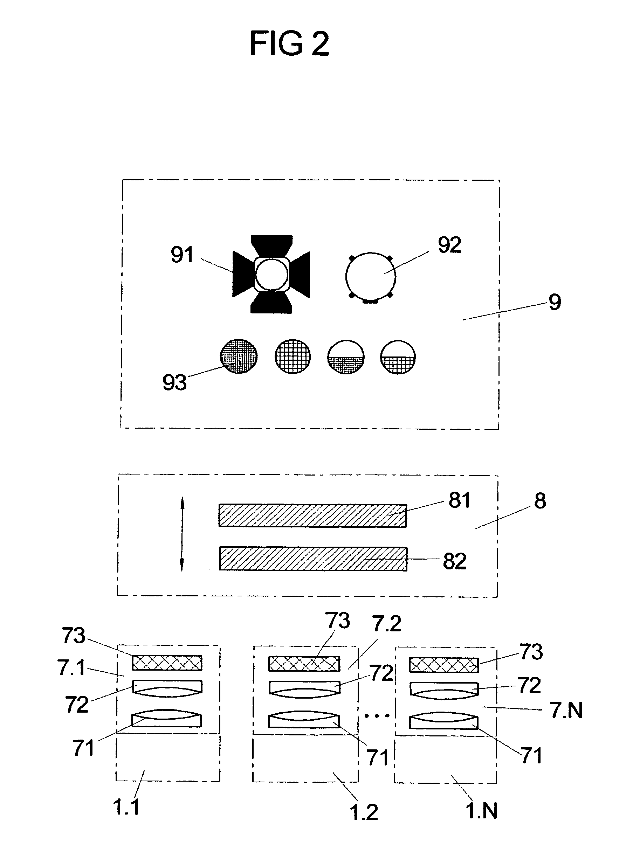

Zur Optimierung des von dem in Fig. 1 schematisch dargestellten Leuchtmodul 1 abgegebenen Lichts kann das Leuchtmodul 1 mit einer Optik oder mehreren Optiken entsprechend der schematischen Darstellung gemäß Fig. 2 erweitert werden.

Zur Erweiterung des aus dem Modulträger 2 mit der Modulelektronik 20 und der Lichtquelle 3 bestehenden Leuchtmoduls 1 kann ein Ring 5 mit der Platine 30 der Lichtquelle 3 verbunden werden, der die LEDs 4 umfasst und gegebenenfalls mit einer vorzugsweise optisch aktiven, die von den LEDs 4 abgegebenen Lichstrahlen sammelnden Vergussmasse 6 ausgefüllt wird. Alternativ kann die Vergussmasse 6 die LEDs 4 der Lichtquelle 3 glocken- oder zylinderförmig abdecken, ohne dass die LEDs 4 von dem Ring 5 eingefasst sind.

Fig. 2 zeigt in schematischer Darstellung mehrere Leuchtmodule 1.1, 1.2 bis 1.N mit einer an die Leuchtmodule 1.1, 1.2 bis 1.N angekoppelten Primäroptik 7.1, 7.2 bis 7.N und einer allen Primäroptiken 7.1, 7.2 bis 7.N zugeordneten Sekundäroptik 8, an eine Tertiäroptik 9 angekoppelt werden kann.

Die Primäroptik 7 dient im Wesentlichen zur Bündelung des von der Lichtquelle 3 des Leuchtmoduls 1 abgegebenen Lichts mittels einer Einrichtung zur Lichtbündelung 71 und/oder zur gleichmäßigen Helligkeitsverteilung des von den LEDs 4 der Lichtquelle 3 abgegebenen Lichts mittels einer Lichtmischeinrichtung 72 und/oder zur Farbmischung des von den Licht unterschiedlicher Wellenlänge und damit unterschiedlicher Farbe abgebenden LEDs 4 der Lichtquelle 3 mittels einer Farbmischeinrichtung 73, wobei zumindest Teile der Primäroptik 7 aus Polymethylmethacrylat (PMMA) oder Polycarbonat (PC) bestehen.

Während das Leuchtmodul 1 und die Primäroptik 7 ein fester Teil des modular aufgebauten Leuchtmoduls 1 der Beleuchtungseinrichtung sind, bilden die Sekundäroptik 8 und die Tertiäroptik 9 einen optionalen und/oder beweglichen Teil, der an spezifische Anforderungen angepasst werden kann, die an ein erweitertes Leuchtmodul der modularen Beleuchtungseinrichtung gestellt werden.

Die Sekundäroptik 8 dient insbesondere der Strahlformung, wird aber auch zur ergänzenden Licht- und/oder Farbmischung eingesetzt. Sie besteht in einer besonderen Ausführungsform aus einer Zoom-Optik, die zwei gegeneinander in Abstrahlrichtung des Leuchtmoduls 1 motorisch, pneumatisch oder hydraulisch verstellbare Mikrolinsenplatten 81, 82 zum Fokussieren, d.h. zum Aufweiten oder Zusammenfassen der von den LEDs 4 abgegebenen Lichtstrahlen enthält. Damit ist es möglich, einen Scheinwerfer zu erzeugen, der in der Bedienung weitgehend einem herkömmlichen Studio- oder Filmscheinwerfer entspricht und der einen dynamisch veränderbaren Halbstreuwinkel von z.B. ca. 20° - 60° aufweist. Alternativ kann die Sekundäroptik 8 aber auch aus einer Kondensorlinse, insbesondere aus einem Wabenkondensor, bestehen.

Die an die Sekundäroptik 8 angekoppelte Tertiäroptik 9 dient im Wesentlichen der Veränderung des Abstrahlwinkels und besteht beispielsweise aus
- einer Blendeneinrichtung in Form von Flügeltoren 91 zur seitlichen Begrenzung des von der Beleuchtungseinrichtung abgestrahlten Lichts,
- Irisblenden,
- Elementen zur Strahlformung oder Erzeugung von Spezialeffekten wie einem Gitter, Diffuser 92, Gobo oder Scrim 93 ,
- Lichtleiter, Spiegel- oder Prismensysteme zur Lichtauskopplung bzw. Lichtkupplung.

Die schematischen Darstellungen der Fig. 1 und 2 zeigen sämtliche Elemente, aus denen das erfindungsgemäße Leuchtmodul 1 für ein modular aufgebautes Beleuchtungssystem zusammengesetzt sein kann, wobei mit Ausnahme des in Fig. 1 dargestellten Leuchtmoduls 1 einzelne oder sämtliche Bauteile 5 bis 9 einschließlich des Rings 5 und der Vergussmasse 6 entfallen oder in Bezug auf die Sekundär- und Tertiäroptik 8, 9 sowohl für einzelne erweiterte Leuchtmodule 1 als auch als gemeinsame Bauteile für mehrere modular zusammengesetzte Leuchtmodule 1 mit jeweils eigenem, aus der Modulelektronik 2, der Lichtquelle 3, optional dem Ring 5 und der Vergussmasse 6, sowie der Primäroptik 7 zusammengesetzten erweiterten Leuchtmodul 1 vorgesehen werden können. So kann beispielsweise ein Scheinwerfer oder eine Flächenleuchte aus
- mehreren jeweils eine eigene Primäroptik 7 aufweisenden Leuchtmodulen 1 mit einer gemeinsamen Sekundäroptik 8 und/oder Tertiäroptik 9;
- mehreren Leuchtmodulen 1 mit einer gemeinsamen Primäroptik 7;
- mehreren erweiterten Leuchtmodulen 1 mit einer gemeinsamen Primäroptik 7 und/oder Sekundäroptik 8 und/oder Tertiäroptik 9
zusammengesetzt werden.

Das Leuchtmodul 1 besteht gemäß den Fig. 1 und 2 in seiner Grundform aus dem Modulträger 2 mit darauf angeordneter Modulelektronik und der auf der Platine 30 angeordneten Lichtquelle 3 und ergibt eine kompakte, universell verwendbare, mikroprozessorgesteuerte Beleuchtungseinrichtung mit Leuchtdioden bzw. LEDs 4, die eine sehr gute Farbwiedergabe und einen großen einstellbaren Farbraum besitzt.

Der optional als Erweiterung des Leuchtmoduls 1 um die LEDs 4 der Lichtquelle 3 angeordnete, vorzugsweise zylinderförmige oder ovale Ring 5 wird beispielsweise mittels einer Klebeverbindung mit der die LEDs 4 aufnehmenden Platine 30 verbunden, besteht vorzugsweise aus Kunststoff und ist auf der den LEDs 4 zugewandten Innenseite weiß oder verspiegelt, um die Lichtstrahlen optimal zu reflektieren, und weist einen definierten Abstand zu den äußeren LEDs 4 sowie eine vorgegebene Höhe auf.

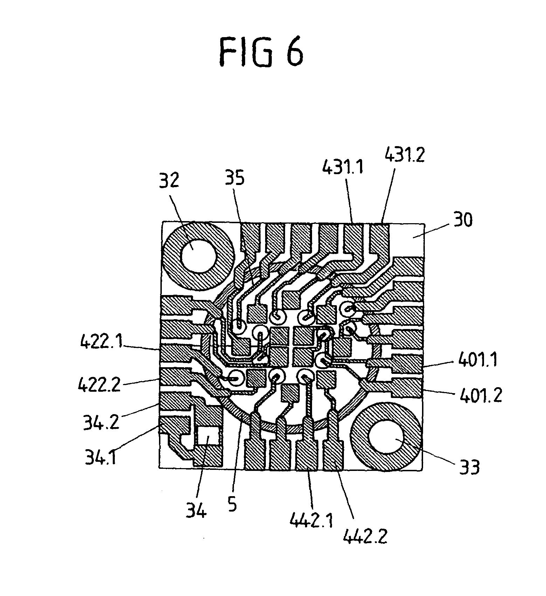

Die transparente Vergussmasse 6 dient als Schutz sowohl für die auf der Platine 30 befestigten LEDs 4 als auch für die die LEDs 4 mit den rasterförmigen, als Lötfahnen ausgebildeten Kontakten 31 gemäß Fig. 6 verbindenden Leiterbahnen 35 und kann darüber hinaus auch als optisch funktionelles Element für die Lichtmischung, Lichtbündelung, Lichtstreuung oder dergleichen des von den LEDs 4 abgestrahlten Lichts dienen.

In einer bevorzugten Ausführungsform füllt die Vergussmasse 6 den durch den zylinderförmigen Ring 5 gebildeten Raum aus, indem die Vergussmasse 6 nach der Verbindung des Ringes 5 mit der Platine 30 der Lichtquelle 3 in den innerhalb des Ringes 5 gebildeten Raum eingebracht wird. Dabei kann die Vergussmasse 6 bündig mit dem oberen Rand des Ringes 5 abschließen, bzw. zur Ausführung optischer Funktionen konvex oder konkav ausgebildet sein.

Die in die Aussparung 21 des Modulträgers 2 eingesetzte Platine 30 der Lichtquelle 3 wird gemäß Fig. 3 mit Verbindungsschrauben, die durch Bohrungen 32, 33 in den Eckbereichen der Platine 30 gesteckt werden, mit einem Kühlkörper verbunden, der in Abhängigkeit von der jeweils vorgesehenen bzw. benötigten Leistung der LEDs 4 verschiedene Kühltechniken anwendet und beispielsweise als belüfteter Kühlkörper mit Kühlrippen oder dergleichen, als Heatpipe oder als flüssigkeitsgekühlter Kühlkörper ausgebildet ist. Die Verbindung der Lichtquelle 3 mit der in Fig. 3 schematisch als gestrichelter Rahmen um die Aussparung 21 dargestellten Modulelektronik 20 erfolgt über die als Lötfahnen ausgebildeten Kontakte 31 am Rand der Platine 30, die mit den Leiterbahnen des Modulträgers 2 verlötet werden.

In einer ersten Alternative zu einer getrennten Anordnung und thermischen Verbindung eines Kühlkörpers mit der Platine 30 der Lichtquelle 3 kann auch der Modulträger 2 der als belüfteter Kühlkörper mit Kühlrippen, als Heatpipe oder als flüssigkeitsgekühlter Kühlkörper ausgebildet sein.

In einer zweiten Alternative kann die Lichtquelle 3 bzw. die Platine 30 auf dem Sockel eines Kühlkörpers angeordnet und dieser durch die Aussparung 21 des Modulträgers 2 gesteckt werden, wie nachstehend anhand der in den Fig. 10 bis 13 dargestellten Ausführungsform erläutert wird.

Weiterhin ist ein Temperatursensor 34 auf der Platine 30 angeordnet, der die Board-Temperatur der Platine 30 und damit der vorzugsweise auf die Platine 30 aufgebondeten LEDs 4 erfasst und ein Temperatursignal an die Modulelektronik 2 abgibt.

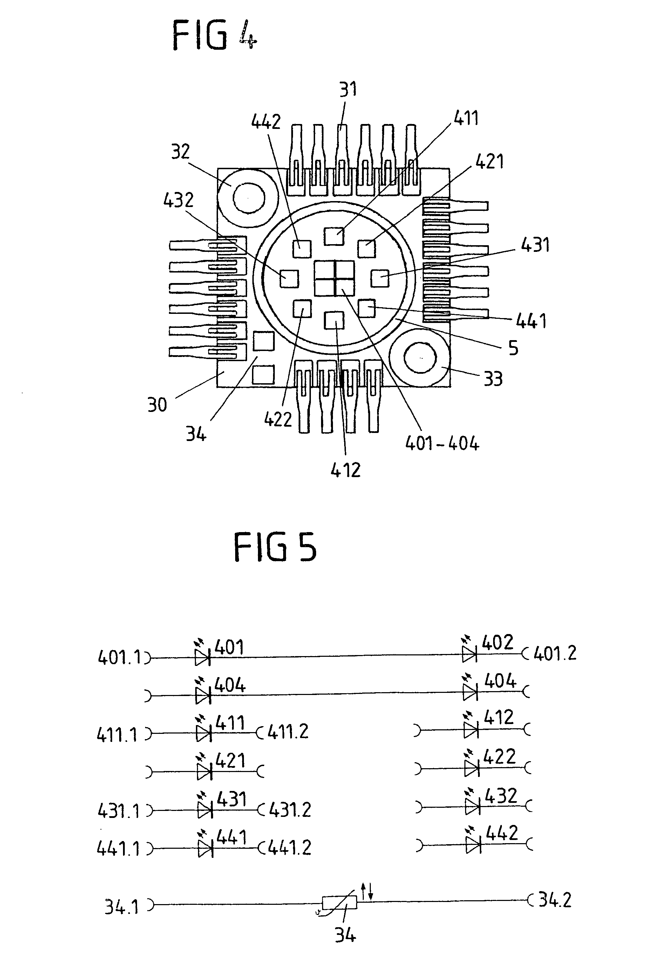

Die in Fig. 4 in einer Draufsicht, in Fig. 5 als Schaltplan und in Fig. 6 als Layout der Schaltungsverbindungen dargestellte erste Ausführungsform einer Lichtquelle 3 enthält zwölf LEDs 401 - 442, die vorzugsweise aus 1 mm² großen Powerchips einer Farbgruppe bestehen und in Chip-On-Board-Technologie auf der als Keramikboard ausgebildeten Platine 30 angeordnet sind. Die zwölf LED-Chips 401 - 442 setzen sich aus
- vier im Zentrum der Lichtquelle 3 zusammengefassten, weißes Licht mit einer dominanten Wellenlänge von 3.200°K abgebenden, paarweise in Serie geschalteten und mit Chipcoating versehenen LEDs 401 - 404 sowie
- konzentrisch und in rotationssymmetrischer Anordnung um die weißes Licht abgebenden LEDs 401 - 404 angeordneten Farb-LEDs 411 - 442 zusammen, von denen jeweils zwei LEDs gleichen Typs bzw. gleicher Farbabgabe, nämlich rotes Licht abgebende LEDs 411, 412, grünes Licht abgebende LEDs 421, 422, blaues Licht abgebende LEDs 431, 432 und gelbes bzw. amberfarbenes Licht abgebende LEDs 441, 442, um jeweils 180° zueinander versetzt auf der Platine 30 angeordnet sind.

Dabei stammen die LEDs 401 - 442 aus einer Helligkeitsgruppe, die aus dem obersten Drittel aller verfügbaren Helligkeitsgruppen besteht, und sind zur optimalen Lichtmischung eng auf der Trägerplatte 30 zusammengefasst.

Die LEDs 401 - 442 der Lichtquelle 3 sind so angeordnet und bezüglich des von ihnen abgegebenen Lichts unterschiedlicher Wellenlänge so ausgewählt, dass eine variable Lichtmischung durch eine getrennte Steuerung der fünf und gegebenenfalls sechs Farbgruppen erzielt wird. Dadurch wird beispielsweise eine Farbtemperatur zwischen 2.000°K bis 25.000°K mit einem Farbwiedergabeindex von CRI > 90 zwischen 2.200°K und 12.000°K bzw. CRI > 94 zwischen 3.200°K und 6.500°K bei einer Leistungsaufnahme von 13,9 W bei 350 mA LED-Nennstrom und einem Lichtstrom von 320 Im bei Nennleistung und einer Junction-Temperatur von T_{J} = 100°C erzielt.

Neben den in Chip-on-Board-Technologie auf der Platine 30 aufgebrachten bzw. aufgebondeten LEDs 401 - 442 weist die Lichtquelle 3 folgende, zumindest teilweise auf der Platine 30 aufgeklebte bzw. aufgelötete Bauteile auf
- den als NTC-Widerstand ausgebildeten Temperatursensor 34 zur Temperaturmessung,
- die als Lötfahnen (lead frames) ausgebildeten elektrischen Kontakte 31, die mit der Modulelektronik 20 verbunden werden und im Raster von 1,27 mm angeordnet sind,
- von den LEDs 401 - 442 zu den elektrischen Kontakten 401.1 - 442.2 führende Leiterbahnen 35,
sowie optional
- den um die LEDs 401 - 442 angeordneten und insbesondere als Optikflansch dienenden Ring 5 mit beispielsweise einem Innendurchmesser von 8 mm und einem Außendurchmesser von 9 mm sowie einer Höhe von 0,7 mm und
- die Vergussmasse 6 zum Schutz der LEDs 401 - 442 und ggf. der Leiterbahnen 35 sowie als optisch funktionelles Bauteil.

Der in Fig. 5 dargestellte Schaltplan der Lichtquelle 3 verdeutlicht die serielle Zusammenschaltung der weißes Licht abgebenden LEDs 401 - 404 sowie der um 180° versetzt zueinander in rotationssymmetrischer Anordnung um die weißes Licht abgebenden LEDs 401 - 404 angeordneten Farb-LEDs 411 - 442 sowie des als NTC-Widerstand ausgebildeten Temperatursensors 34, der mit den elektrischen Kontakten 34.1 und 34.2 der rasterförmigen Anordnung der als Lötfahnen ausgebildeten Kontakten 31 der Lichtquelle 3 verbunden ist.

Fig. 6 zeigt das zu den Darstellungen gemäß den Figuren 4 und 5 gehörende Layout der Verbindungen der LEDs 401 - 442 der Lichtquelle 3 mit den rasterförmig am Rand der Platine 30 angeordneten Kontakte 31 über Leiterbahnen 35 sowie des Temperatursensors 34 und verdeutlicht die auch bei gedrängtem Aufbau der LEDs 401 - 442 zur Erzielung einer optimalen Lichtmischung problemlos zu verlegenden elektrischen Leiterbahnen 35 sowie die Umrisse des zylinderförmigen Rings 5 der Lichtquelle 3 und die diametral zueinander angeordneten Bohrungen 32, 33 zur Verbindung der Platine 30 der Lichtquelle 3 mit dem Modulträger 2 oder einem Kühlkörper.

Entsprechend dem Schaltplan gemäß Fig. 5 und dem Layout in Fig. 6 sind jeweils zwei weißes Licht abgebende LEDs 401 und 402 bzw. 403 und 404 in Serie geschaltet an die Kontaktflächen 401.1 und 402.2 bzw. 403.1 und 404.2 angeschlossen, die mit den entsprechenden Kontakten 31 am Rand der Platine 30 der Lichtquelle 3 verbunden sind. Analog sind die rotes Licht abgebenden LEDs 411, 412 mit den Kontaktflächen 411.1 und 411.2 bzw. 412.1 und 412.2, die grünes Licht abgebenden LEDs 421, 422 mit den Kontaktflächen 421.1 und 421.2 bzw. 422.1 und 422.2, die blaues Licht abgebenden LEDs 431, 432 mit den Kontaktflächen 431.1 und 431.2 bzw. 432.1 und 432.2 und die gelbes bzw. amberfarbenes Licht abgebenden LEDs 441, 442 mit den Kontaktflächen 441.1 und 441.2 bzw. 442.1 und 442.2 verbunden.

Die in Fig. 3 mit gestrichelten Linien auf dem Modulträger schematisch eingezeichnete Modulelektronik 20 weist eine auf dem doppelseitig bestückten, als Leiterplatte ausgebildeten Modulträger 2 angeordnete Mikroprozessorschaltung auf, die beispielsweise um die die Lichtquelle 3 bzw. den Sockel 161 des Modul-Kühlkörpers 16 aufnehmende Aussparung 21 herum angeordnet ist und die auf ihrer seriellen Schnittstelle empfangenen Befehle verarbeitet und daraus Steuersignale für die Ansteuerung der LEDs 401 - 442 über die rasterförmig angeordneten Kontakte 31 erzeugt, die über die Leiterbahnen 401.1 - 442.2 mit den einzelnen, seriell zusammen geschalteten LEDs 401 - 442 verbunden sind. Die Ansteuerung der LEDs 401 - 442 erfolgt vorzugsweise über präzise pulsweitenmodulierte Steuersignale, deren Pulsweite zur stufenlosen Dimmung der LEDs von 0 % bis 100 % eingestellt werden kann.

In dem in den Fig. 3 bis 6 dargestellten Ausführungsbeispiel erzeugt die Modulelektronik 2 sechs pulsweitenmodulierte Steuersignale zur Ansteuerung der LEDs 401 - 442 der Lichtquelle 3, wobei auf jedem Farbkanal die folgenden Signale bzw. Werte verarbeitet werden
- die Helligkeit des von den LEDs 401 - 442 abgegebenen weißen bzw. farbigen Lichts durch Vorgabe eines Strom-Sollwertes I_{SOLL} von der seriellen Schnittstelle,
- die Grundhelligkeit durch eine unkorrigierte Helligkeit des Farbkanals bei Nennbedingungen,
- die Temperatur durch das von dem Temperatursensor 34 der Lichtquelle 3 abgegebenen Temperatursignal T_{Board},
- eine Kennliniensteuerung mit den Koeffizienten A, B, C für die Temperaturkompensation der Helligkeit mit einer quadratischen Kennlinie (I = A x T_{Board}² + B x T_{Board} + C) und
- die Systemtemperatur, d. h. die höchste Temperatur Tₘₐₓ in der Beleuchtungseinrichtung bzw. dem Leuchtmodul 1 zur Kompensation von konvektionsbedingten Helligkeitsunterschieden.

Der doppelseitig kupferkaschierte und doppelseitig in SMD (Service Mounted Devices) - Technik bestückte Modulträger 2 weist beispielsweise die äußeren Abmessungen 36 x 36 mm mit einer Aussparung von 14 x 14 mm für die Aufnahme der Lichtquelle 3 auf und enthält mindestens eine Kontaktleiste 23 als äußeren Anschluss sowie den als Lötflächen zu den Kontakten 31 der Lichtquelle 3 ausgebildeten inneren Anschlüssen.

Die einzelnen, die Modulelektronik 20 enthaltendenen Leuchtmodule 1 arbeiten als Bus-Slaves und starten keine spontane Kommunikation. Bei einer Zusammenschaltung mehrerer Leuchtmodule 1 zur Bildung eines Gesamtsystems einer modularen Beleuchtungseinrichtung führt ein mit den Modulelektroniken 20 der einzelnen Leuchtmodule 1 über serielle Schnittstellen verbundener externer Controller eine periodische Abfrage aller Board-Temperaturen der Leuchtmodule 1 im Gesamtsystem durch und sendet anschließend die höchste ermittelte Temperatur an die einzelnen Modulelektroniken 20 der Leuchtmodule 1 des Gesamtsystems zurück. Nach einem Synchronisationsbefehl führen alle Leuchtmodule 1 eine Helligkeitsanpassung auf Basis dieses an die Leuchtmodule 1 zurückgesendeten Temperaturwertes durch, um konvektionsbedingte Helligkeitsunterschiede zwischen den einzelnen Leuchtmodulen 1 auszugleichen.

Die an die LEDs 4 der einzelnen Leuchtmodule 1 abgegebenen Farbsignale weisen in einer Ausführungsform eine maximale Spannung von 9 V bei einer maximalen Stromstärke von 350 mA auf. Die Pulsweitenmodulation wird mit einer Frequenz f ≥ 25 kHz bei einer 12 bit-Auflösung durchgeführt. Die Effektiv-Stromregelung erfolgt mit einer Toleranz von Δ*I_{EFF}* ≤ +1% durch Regelung des maximalen Stromwertes I_{MAX} auf ± 10% und/oder einen Ausgleich der Pulsweite der Pulsweitenmodulation.

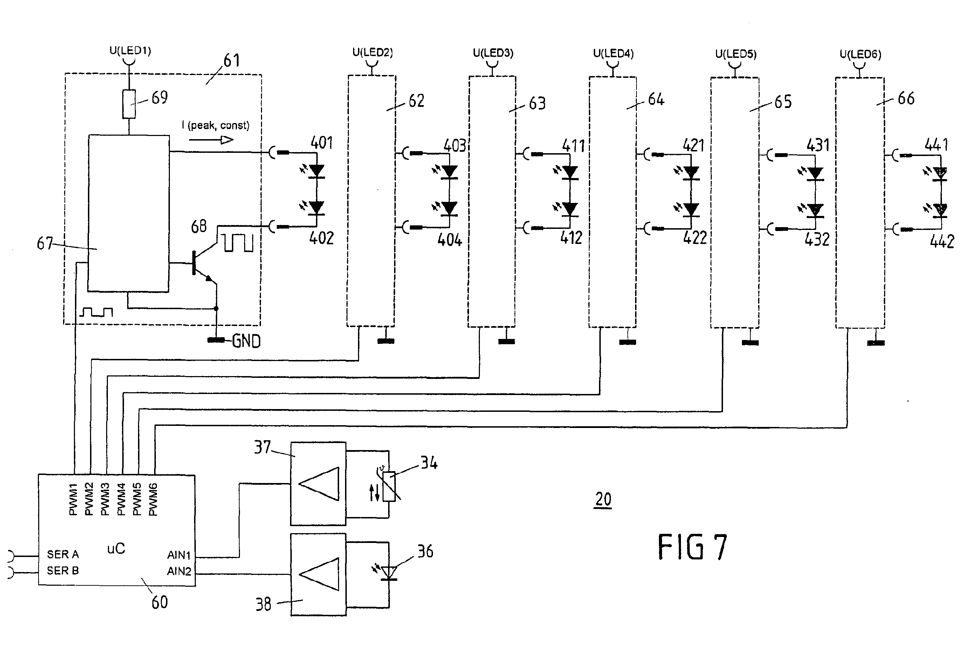

Fig. 7 zeigt ein Funktionsschaltbild der Modulelektronik 20 zur Ansteuerung von sechs LED-Gruppen mit jeweils zwei in Reihe geschalteten, Licht gleicher Wellenlänge abgebenden LEDs 401, 402; 403, 404; 411, 412; 421, 422; 431, 432; 441, 442 sowie zur Regelung der von den LEDs abgegebenen Lichtmischung durch eine Helligkeitsansteuerung der einzelnen LED-Gruppen mittels einer pulsweitenmodulierten Steuerspannung und Ansteuerung einer temperaturstabilisierten Stromquelle zur Speisung der LED-Gruppen.

Die Modulelektronik 20 enthält einen Microcontroller 60, der sechs pulsweitenmodulierte Steuerspannungen PWM1 bis PWM6 an sechs identisch aufgebaute Konstantstromquellen 61 bis 66 abgibt. Der Microcontroller 60 ist über eine serielle Schnittstelle SER A und SER B mit einem externen Controller verbunden und weist Eingänge AIN1 und AIN2 auf, die über Verstärker 37, 38 mit einem Temperatursensor 34 und einem Helligkeits- oder Farbsensor 36 des Leuchtmoduls verbunden sind.

Die identisch aufgebauten Stromquellen 61 bis 66 sind sehr gut temperaturstabilisiert und enthalten eine temperaturstabilisierte Konstantstromquelle 67, die mit jeweils einem Ausgang PWM1 bis PWM6 der die pulsweitenmodulierten Steuerspannungen abgebenden Ausgänge PWM1 bis PWM6 des Microcontrollers 60 verbunden und über einen Widerstand 69 an eine Versorgungsspannung U_{LED1} bis U_{LED6} angeschlossen sind. Die temperaturstabilisierte Konstantstromquelle 67 ist ausgangsseitig mit der Anode der in Reihe geschalteten LEDs einer LED-Gruppe, die jeweils Licht gleicher Wellenlänge abgeben, und mit dem Steueranschluss eines elektronischen Schalters 68 verbunden, der einerseits mit der Kathode der in Reihe geschalteten LEDs und andererseits mit Massepotential GND verbunden ist.

Die temperaturstabilisierte Konstantstromquelle 67 zeichnet sich durch ein schnelles und sauberes Schalten mit einer Schaltfrequenz von 20 bis 40 kHz aus. Um die Verlustleistung des Leuchtmoduls so gering wie möglich zu halten, werden die in der Herstellungstechnologie unterschiedlichen LED-Chips mit bis zu sechs unterschiedlichen Versorgungsspannungen U_{LED1} bis LED6 gespeist.

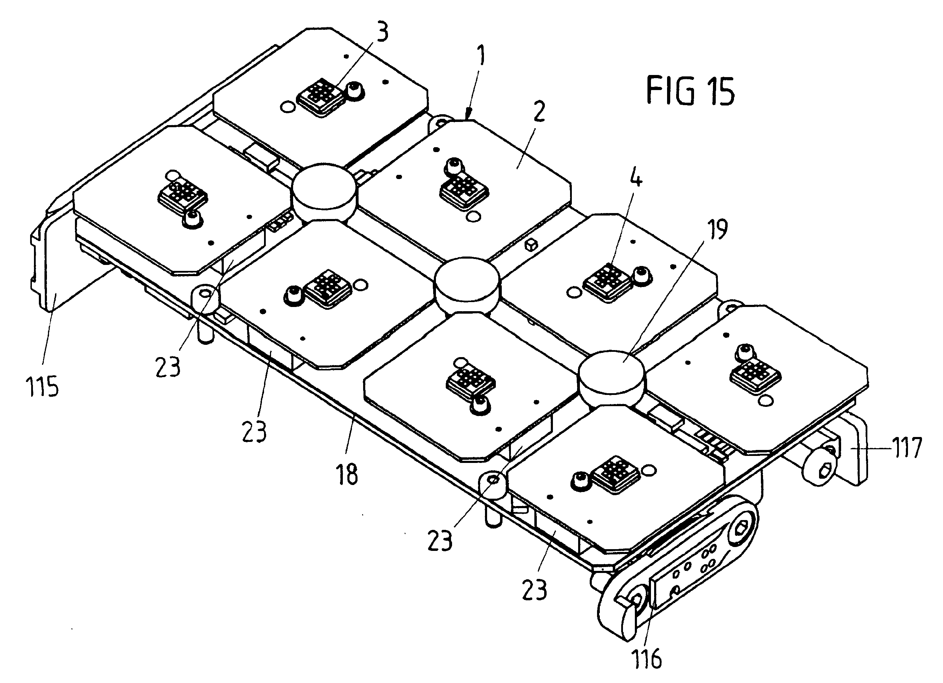

Mit der Anordnung der temperaturstabilisierten Stromquellen 61 - 66 auf dem Modulträger des Leuchtmoduls wird die Modularität des Systems verbessert und die Spannungsversorgung vereinfacht. Bei einer Reduzierung der unterschiedlichen Versorgungsspannungen U_{LED1} bis U_{LED6} durch eine Anwendung von nur zwei verschiedenen Spannungen zur gruppenweise zusammengefassten Spannungsversorgung der Stromquellen 61 - 66 für beispielsweise die roten und gelben LEDs einerseits und die blauen, grünen und weißen LEDs andererseits benötigt das Leuchtmodul nur noch fünf Schnittstellen, d. h. eine Verbindung des Leuchtmoduls über fünf Leitungen, nämlich zwei Versorgungsspannungen V_{LED1} und V_{LED2}, Massepotential GND und die seriellen Schnittstellen SER A und SER B mit einem externen Controller 10 (Fig. 15) zur übergeordneten Steuerung und Regelung einer Vielzahl gleichartig aufgebauter Leuchtmodule.

Die in den Fig. 3 bis 6 dargestellte Anordnung der LEDs 4 einer Lichtquelle 3 mit vier im Zentrum der Lichtquelle 3 zusammengefassten, weißes Licht abgebenden und paarweise in Serie geschalteten LEDs sowie konzentrisch und in rotationssymmetrischer Anordnung um diese weißes Licht abgebenden LEDs angeordneten Farb-LEDs kann unter Beibehaltung einer engen Anordnung der LEDs 4 auf der Platine 30 der Lichtquelle 3 zur optimalen Lichtmischung in Abhängigkeit von der jeweiligen Aufgabenstellung variiert werden.

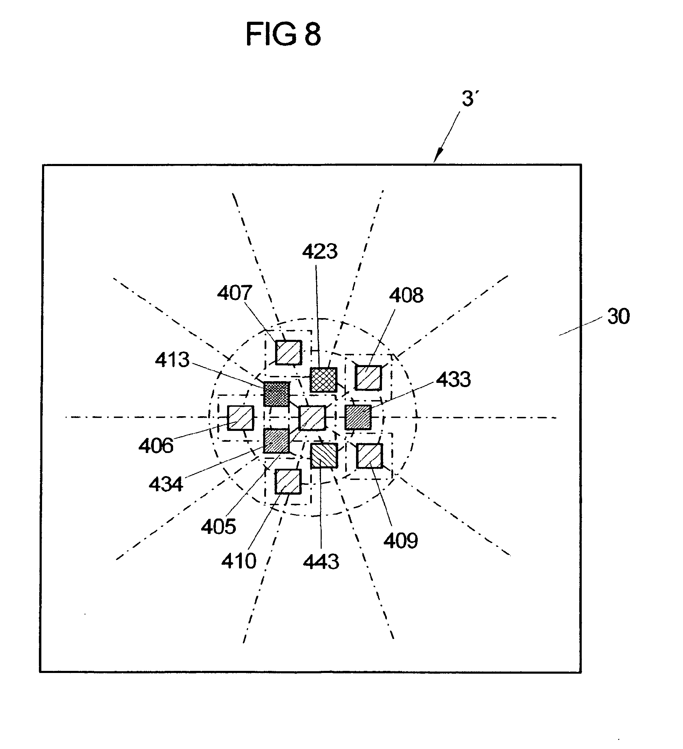

In Fig. 8 ist eine Draufsicht auf eine Lichtquelle 3' mit einer alternativen Anordnung von elf LEDs 405 bis 443 auf einer Platine 30 dargestellt, die Licht unterschiedlicher Farbe abgeben. Die LEDs 405 bis 443 sind im Mittelpunkt und auf zwei konzentrischen Kreisen um den Mittelpunkt sowie auf den beiden konzentrischen Kreisen in gleichen Winkelabständen angeordnet, so dass einerseits gewährleistet ist, dass die LEDs 405 bis 443 eng zueinander auf der Platine 30 stehen und zum Anderen eine äußere kreisförmige Begrenzung ergeben, die sich optimal zum Anflanschen einer Optik an die Lichtquelle 3' eignet.

Im Mittelpunkt der LED-Anordnung gemäß Fig. 8 ist ein weißes, insbesondere warmweißes Licht mit einer Farbtemperatur von 3.200°K abgebender LED-Chip 405 angeordnet. Auf dem äußeren der konzentrischen Kreise sind fünf ebenfalls weißes, insbesondere warmweißes Licht abgebende LED-Chips 406 bis 410 angeordnet, während auf dem Inneren der beiden konzentrischen Kreise ein erster, blaues Licht abgebender LED-Chip 433, ein gelbes oder amberfarbenes Licht abgebender LED-Chip 443, ein zweiter, blaues Licht abgebender LED-Chip 434, ein rotes Licht abgebender LED-Chip 413 und ein grünes Licht abgebender LED-Chip 423 angeordnet sind. Sowohl die auf dem inneren Kreis als auch die auf dem äußeren Kreis der beiden konzentrischen Kreise angeordneten LED-Chips 405 bis 443 sind in gleichen Winkelabständen von 72° angeordnet und die auf dem inneren der beiden konzentrischen Kreise angeordnete LED-Chips 413, 423, 433, 443 und 434 um einen Winkel von 36° gegenüber den auf dem äußeren der beiden konzentrischen Kreise angeordneten LED-Chips 406 bis 410 versetzt.

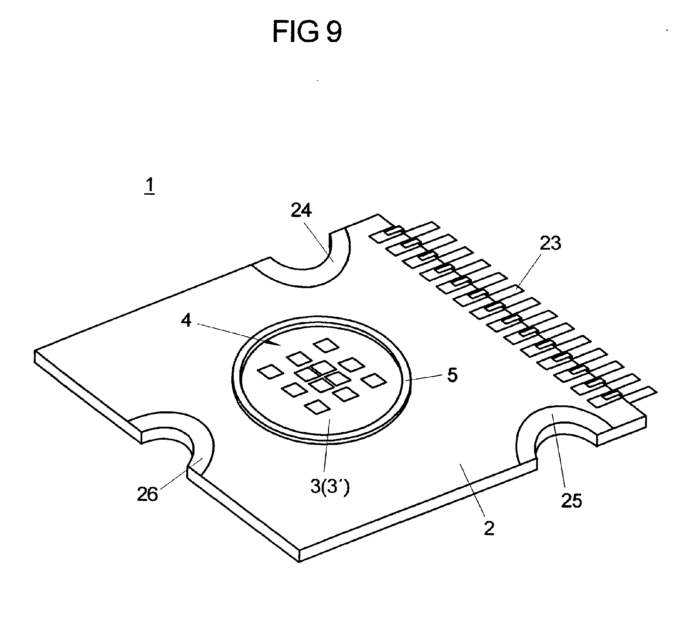

Fig. 9 zeigt als Ausführungsbeispiel eine perspektivische Darstellung eines für eine Aneinanderreihung gleichartiger Leuchtmodule geeigneten Leuchtmoduls 1, das aus einem viereckigen, als Leiterplatte ausgebildeten Modulträger 2, einer Lichtquelle 3 oder 3' mit mehreren, in diesem Ausführungsbeispiel zwölf LEDs 4, die paarweise Licht unterschiedlicher Wellenlänge und damit Farbe abgeben, einem Ring 5 und einer Kontaktleiste 23 zusammengesetzt ist. An den beiden an die Kontaktleiste 23 angrenzenden Seiten und an der der Kontaktleiste 23 gegenüberliegenden Seite sind halbkreisförmig ausgebildete Befestigungsaufnahmen 24, 25, 26 vorgesehen, die durch das Anfügen weiterer, gleichartig ausgebildeter viereckiger Modulträger 2 mit halbkreisförmig ausgebildeten Befestigungsaufnahmen 24, 25, 26 eine geschlossene Kreisform der Befestigungsaufnahmen zur Aufnahme von Befestigungselementen ergeben, so dass die so zusammengefügten Leuchtmodule eine modulare, beispielsweise als Scheinwerfer oder Flächenleuchte ausgebildete Beleuchtungseinrichtung ergeben.

Alternativ können Beleuchtungseinrichtungen auch aus Leuchtmodulen mit dreieckförmigem Modulträger 2 gebildet werden, die analog zu dem vorstehend anhand der Fig. 9 beschriebenen Leuchtmodul halbkreisförmig ausgebildete Befestigungsaufnahmen aufweisen, die bei einer Aneinanderreihung weiterer, gleichartig ausgebildeter dreieckiger Trägerplatten zu einer Kreisform zur Aufnahme von Befestigungselementen geschlossen werden.

Weiterhin können durch die Aneinanderreihung von Leuchtmodulen mit dreieckförmiger Trägerplatte und aus Leuchtmodulen mit viereckigen Trägerplatten, gegebenenfalls auch durch Links- und Rechtsdrehung der einzelnen Leuchtmodule, beliebige geometrische Formen für eine Beleuchtungseinrichtung, beispielsweise für einen Scheinwerfer, für Leuchtpaneele, Ringlichter für Kameraobjektive, Lichtketten, LED-Schlangen oder LED-Ketten mit zickzackförmig aneinander gereihten Paneelen und dergleichen erzeugt werden.

In den Fig. 10 bis 13 ist ein weiteres Ausführungsbeispiel eines Leuchtmoduls 1 in seinen Einzelteilen und im zusammengebauten Zustand dargestellt, das sich neben einer optimalen Wärmeableitung durch eine sichere und einfache mechanische Verbindung zwischen dem Leuchtmodul 1 und einem Scheinwerfergehäuse bzw. einer Kühleinrichtung auszeichnet, wobei der Modulträger 2 mechanisch nicht belastet wird und die Lichtquelle 3 so angeordnet wird, dass der Strahlengang der LEDs 4 der Lichtquelle 3 nicht durch Befestigungselemente auf dem Modulträger 2 oder durch elektronische Bauteile der Modulelektronik 20 gestört wird, die auf dem als quaderförmige Metallkernplatine 300 ausgebildeten Modulträger 2 angeordnet sind, so dass die in Abstrahlrichtung der Lichtquelle 3 nachgeordnete Optik die von den LEDs 4 abgegebenen Lichtstrahlen auffangen und sehr effektiv gestalten kann.

Die in Fig. 10 schematisch-perspektivisch dargestellte Lichtquelle 3 dieses Leuchtmoduls setzt sich aus zwölf LEDs 401 - 403, 411, 412, 421, 422, 431, 432 und 441, 442 und einem Temperatursensor 34 zusammen, die auf der Metallkernplatine 300 zusammen mit Leiterbahnen 35 angeordnet sind, die von den LEDs 401 - 403, 411, 412, 421, 422, 431, 432 und 441, 442 und vom Temperatursensor 34 zu den Rändern der quaderförmigen Metallkernplatine 300 geführt sind, wo sie über eine direkte Draht- oder Bond-verbindung mit der Modulelektronik verbunden werden. Dieser Aufbau ermöglicht den Aufbau einer sehr kleinen und damit kostengünstigen Lichtquelle mit hoher Leuchtdichte.

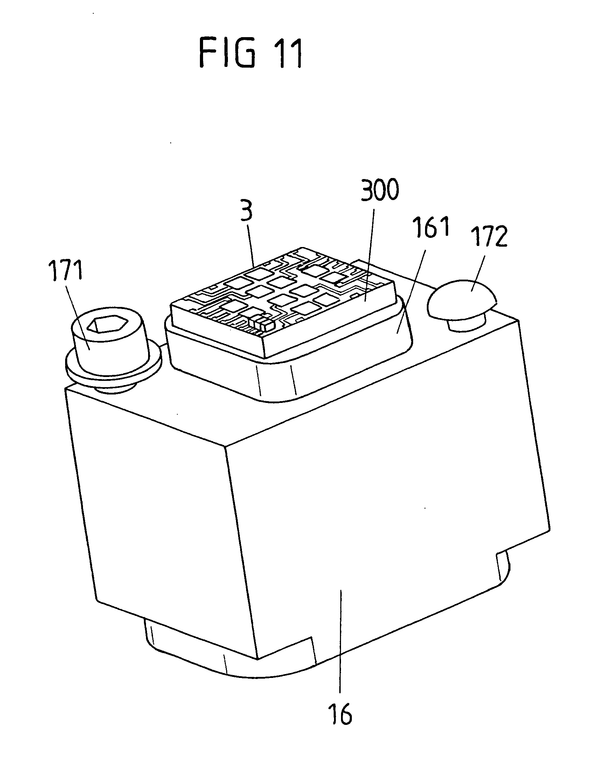

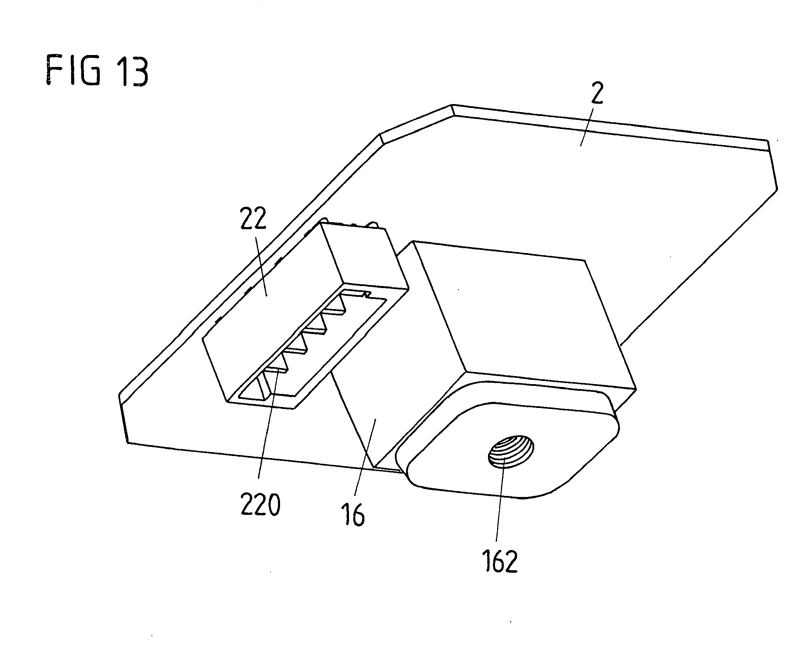

Zur optimalen Ableitung der von der Lichtquelle 3 abgegebenen Wärme im Betrieb des Leuchtmoduls ist die Metallkernplatine 300 gemäß Fig. 11 mit der Oberfläche eines Sockels 161 eines Modul-Kühlkörpers 16 verbunden, der eine Quader- oder Würfelform aufweist, aus einem sehr gut Wärme leitenden Material wie beispielsweise Kupfer oder Aluminium besteht und gemäß Fig. 13 auf seiner Unterseite eine Bohrung mit Gewinde 162 aufweist, über die eine sichere und einfache mechanische Verbindung des gesamten Leuchtmoduls mit einem Scheinwerfergehäuse oder einer Kühleinrichtung über Norm-Befestigungselemente, wie Schrauben, Stifte und dergleichen, hergestellt werden kann.

Der Modul-Kühlkörper 16 kann über Kühlmittelleitungen mit einem Wärmetauscher verbunden werden. Eine Flüssigkeitskühlung des Modul-Kühlkörpers 16 und damit des Leuchtmoduls bietet sich beispielsweise bei der Anordnung eines Beleuchtungsgeräts an einem Teleskop unterhalb einer Studiodecke an und ermöglicht eine effektive Kühlung, da nur die Teile gekühlt werden, die Wärme erzeugen. Eine weitere Möglichkeit besteht darin, den Modul-Kühlkörper 16 bzw. das Beleuchtungsgerät über Kühlmittelleitungen mit einem externen Steuer- und Kühlgerät zu verbinden oder ein als Einzelspot ausgebildetes Kameralicht oder kleines Array mit einem Wärmerohr (Heatpipe) und einem Fächerkühlkörper zu verwenden.

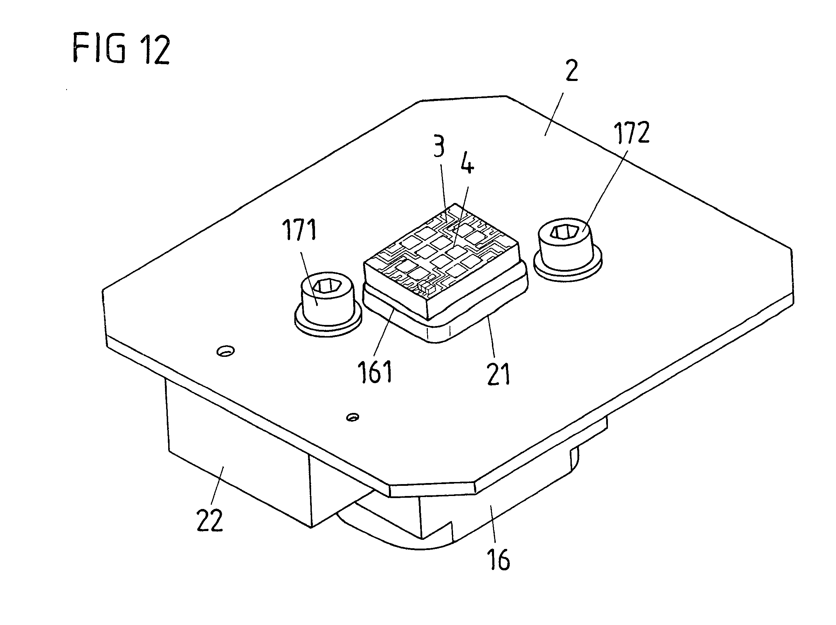

Der über die Oberfläche des Modul-Kühlkörpers 16 hinausragende Sockel 161 weist eine Oberfläche auf, die in etwa der Oberfläche der Metallkernplatine 300 entspricht. Seitlich des Sockels 161 sind Bohrungen zur Aufnahme von Befestigungselementen, wie Schrauben 171 oder Kerbnägeln 172, in die Oberfläche des Modul-Kühlkörpers 16 eingelassen, die eine sichere Verbindung mit dem als Leiterplatte ausgebildeten Modulträger 2 ermöglichen, der gemäß den Fig. 12 und 13 eine zentrale Ausnehmung 21 aufweist, durch die der Sockel 161 des Modul-Kühlkörpers 16 gesteckt ist, so dass die Oberfläche der Lichtquelle 3 mit den darauf angeordneten LEDs 4 sich zumindest in gleicher Höhe, vorzugsweise jedoch oberhalb der Befestigungselemente 171, 172 sowie der auf der Oberseite des Modulträgers 2 angeordneten, nicht weiter dargestellten elektronischen Bauteile der Modulelektronik 20 befindet, so dass der Strahlengang der LEDs 4 nicht gestört wird.

Durch die Verbindung des Modulträgers 2 mit dem Modul-Kühlkörper 16 über die Befestigungselemente 171 bzw. 172 wird gewährleistet, dass der Modulträger 2 mechanisch nicht belastet wird und dass durch das Aufstecken des Modulträgers 2 auf den Sockel 161 des Modul-Kühlkörpers 16 ein flacher, platzsparender Aufbau erzielt wird. Das gesamte Leuchtmodul kann somit über die am Boden des Modul-Kühlkörpers 16 angeordnete Gewindebohrung 162 und ein mit der Gewindebohrung 162 verschraubtes Befestigungselement an einem größeren Kühlkörper oder an einem Scheinwerfergehäuse befestigt werden, wobei es thermisch von Vorteil ist, wenn die Lichtquelle 3 unmittelbar am Modul-Kühlkörper 16 angekoppelt ist.

Die Verbindung der Modulelektronik mit einem in Fig. 15 dargestellten externen Controller 10 erfolgt gemäß Fig. 12 über einen Kontaktstecker 22, der auf der Unterseite des Modulträgers 2 angeordnet ist und gemäß Fig. 13 bei einer Spannungsversorgung der Modulelektronik mit zwei unterschiedlichen Versorgungsspannungen fünf Kontakte aufweist. Eine mit dem Kontaktstecker 220 verbindbare Kontaktbuchse weist dementsprechend fünf Buchsen auf, die mit zwei Spannungsquellen, einem Massepotential und mit zwei Kontakten einer seriellen Schnittstelle zum externen Controller verbunden sind.

Das in den Fig. 10 bis 13 dargestellte Leuchtmodul ermöglicht eine sehr einfache und Platz sparende, flache Anordnung mehrerer gleichartiger Leuchtmodule auf der Platine eines LED-Panel (Motherboard oder Backplane), das beispielsweise mit einem Beleuchtungsgerät, wie einem Scheinwerfer, verbunden wird.

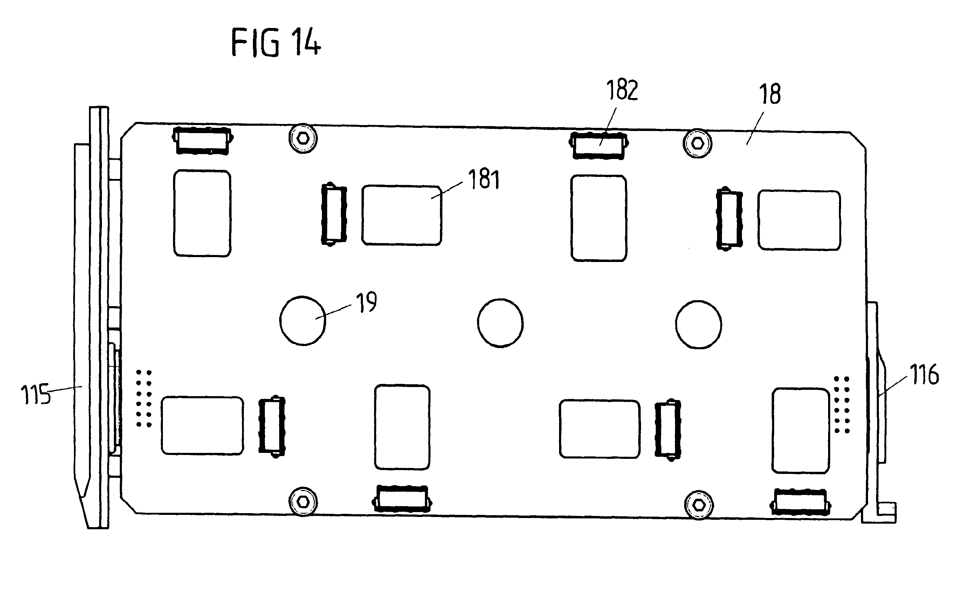

Ein Ausführungsbeispiel für eine derartige als Motherboard ausgebildete Platine 18, die unter anderem den externen Controller 10 und weitere Speicher-, Steuer- und Schnittstellenelemente eines LED-Panels für ein LED-Beleuchtungssystem aufnimmt, ist in den Fig. 14 bis 16 dargestellt.

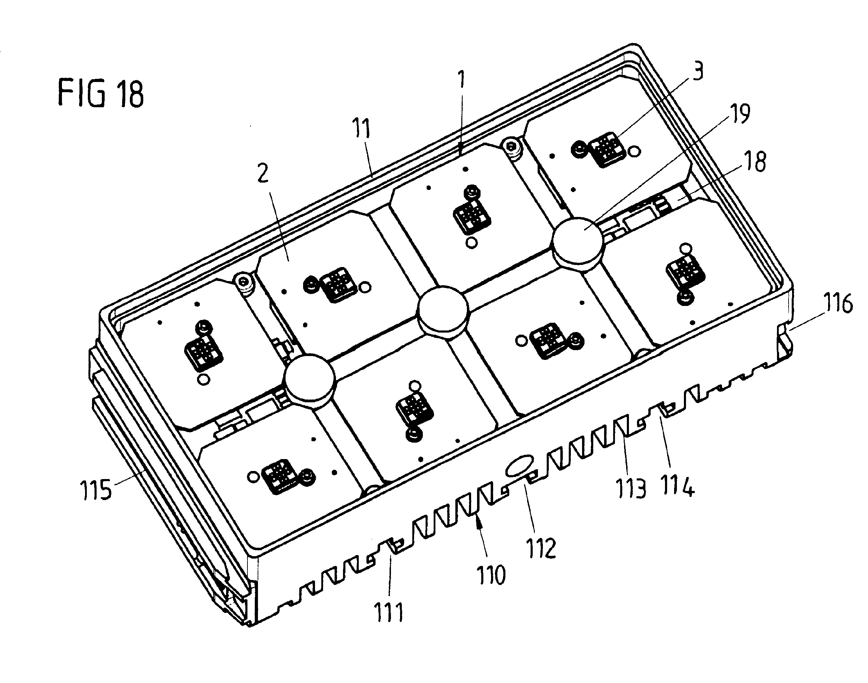

Fig. 14 zeigt eine Draufsicht auf die Platine 18 eines LED-Panels, die unter anderem einen externen Controller und weitere Speicher-, Steuer- und Schnittstellenelemente aufweist. In der rechteckigen Platine 18 sind acht Öffnungen 181 zum Einsetzen der Modul-Kühlkörper 25 des Leuchtmoduls 2 sowie acht Steckbuchsen 182 zur Aufnahme der Kontaktstecker 23 der einzelnen Leuchtmodule 2 mit jeweils unterschiedlicher Ausrichtung der Öffnungen 181 und Steckbuchsen 182 für die Modul-Kühlkörper 25 bzw. Kontaktstecker 23 vorgesehen. Zum besseren Verständnis sind in der Draufsicht gemäß Fig. 14 die auf der Platine 18 beidseitig angeordneten elektronischen Bauteile der Speicher- und Steuerelemente weggelassen. An ihren Schmalseiten weist die rechteckförmige Platine 18 Eingangs- und Ausgangs-Steckverbinder 115, 116 auf, die senkrecht zur Ebene der Platine 18 ausgerichtet sind und Ein- und Ausgänge für ein in Fig. 18 dargestelltes LED-Panel bilden. Mittig auf der Platine 18 sind beabstandet zueinander Befestigungsmagnete 19 zum Befestigen einer optischen Einrichtung (Primär- und Sekundäroptik) angeordnet.

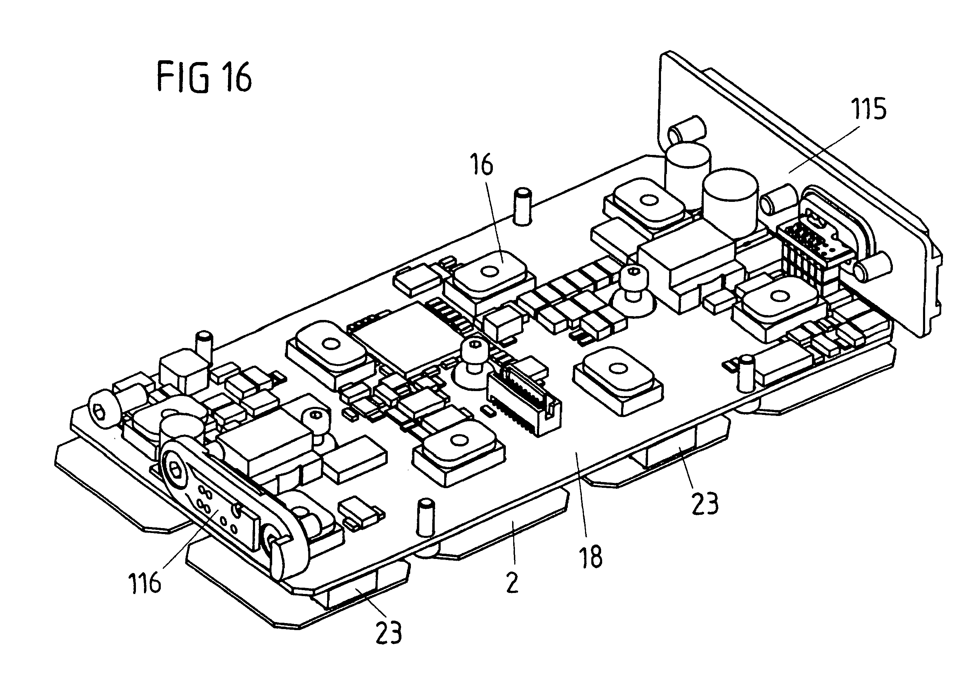

In den Fig. 15 und 16 ist in einer isometrischen Ansicht auf die Oberseite und Unterseite der Platine 18 die Anordnung der Leuchtmodule 1 mit dem Modulträger 2, der Lichtquelle 3 und den LEDs 4, der in die Öffnungen 181 der Platine 18 eingesetzten Modul-Kühlkörper 25 und der in die Steckbuchsen 182 eingesetzten Kontaktstecker 23, sowie die Anordnung der Befestigungsmagnete 19, der nicht näher bezeichneten elektronischen Bauteile der Speicher- und Steuerelemente des LED-Panels und mehrerer Eingangs- und Ausgangs-Steckverbinder 115, 116, 117 dargestellt.

Insgesamt bietet das anhand der Fig. 1 bis 13 beschriebene Leuchtmodul die Vorzüge einer einstellbaren, präzisen Lichtquelle mit mehreren LEDs und integrierter Mikroprozessorschaltung, die einen sehr großen Farbraum und Farbtemperaturbereich von beispielsweise 2.000°K bis 25.000°K sowie eine sehr gute Farbwiedergabe mit einem Farbwiedergabeindex CRI > 90 zwischen 2.200°K und 12.000°K sowie einem Farbwiedergabeindex CRI > 95 zwischen 3.200°K und 6.500°K bei einer LED-Leistung von bis zu 12 W ermöglicht. Darüber hinaus ist ein Lichtstrom bis zu 300 Im in der Einstellung "weiß" bei 100°C Junction-Temperatur zu erzielen.

Das Leuchtmodul ermöglicht bis zu sechs unabhängige Farbkanäle mit einer Standardbestückung in den Farben Rot, Grün, Blau, Weiß und Amber und eine sehr hohe Leuchtdichte durch die kreisförmige Anordnung von beispielsweise zwölf LED-Chips mit einem Durchmesser von jeweils 5,6 mm.

Der Anwendungsbereich des Leuchtmoduls ist durch die Ankopplung von Optiken, auch mit engem Streuwinkel, erweiterbar, ohne dass Farbdivergenzen auftreten. Der modulare Aufbau der Beleuchtungseinheit ermöglicht eine Aneinanderreihung von einer Vielzahl sich gleich verhaltender Leuchtmodule sowie eine Zusammenfassung der Steuerung an einem externen Controller mit Download-Funktion für das Betriebsprogramm und die Parameter und einen Datenaustausch über eine serielle Schnittstelle.

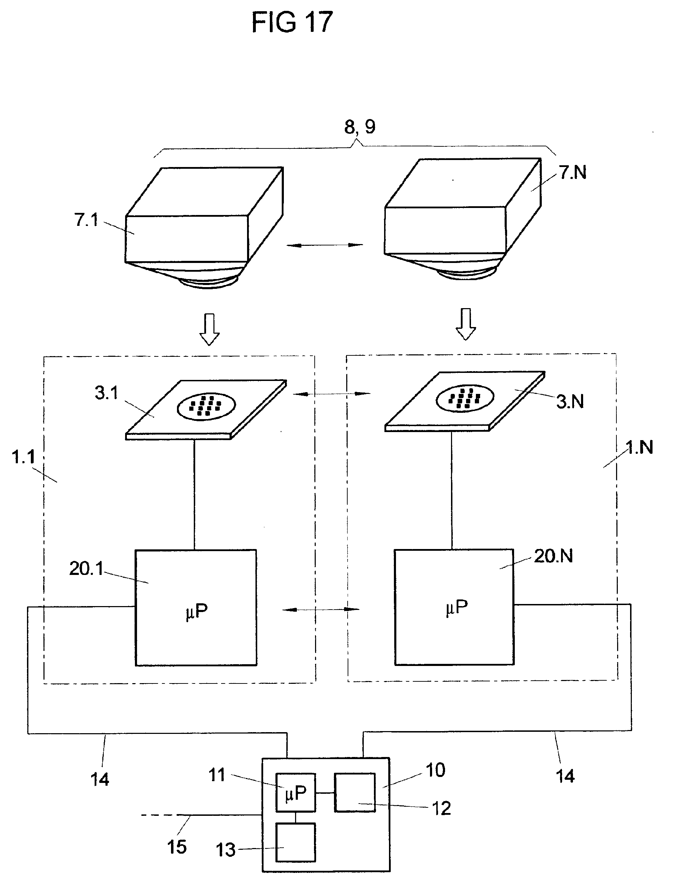

Die von der Lichtquelle 3 abgegebene Lichtmischung wird individuell für jedes Leuchtmodul 1 oder in einer Gesamtheit mehrerer zu einer Beleuchtungseinrichtung zusammengefasster Leuchtmodule 1 weiterbehandelt. So kann beispielsweise aus einer Anzahl von N Leuchtmodulen 1 ein Gesamtsystem für eine als LED-Panel, Scheinwerfer, Lichterkette oder dergleichen ausgebildete Beleuchtungseinrichtung gebildet werden, wobei eines der Leuchtmodule 1 als Master-Modul ausgebildet ist und die Kenn- und Kalibrierdaten der Beleuchtungseinrichtung enthält, während die weiteren Leuchtmodule 1 als Slave-Module ausgebildet sind. Alle Leuchtmodule 1 des Gesamtsystems kommunizieren in einer derartigen Anordnung mit einem externen Steuergerät bzw. Controller. Eine Zusammenfassung von N Leuchtmodulen 1 zu einem Gesamtsystem wird nachstehend anhand der in den Fig. 17 und 18 dargestellten LED-Beleuchtungseinrichtung erläutert.

Fig. 17 zeigt eine schematische Darstellung des Schaltungsaufbaus einer Zusammenschaltung von N Leuchtmodulen 1.1 bis 1.N zu einer Beleuchtungseinrichtung, die von einem externen Controller 10 gesteuert wird.

Die Leuchtmodule 1.1 bis 1.N enthalten entsprechend der vorstehenden Beschreibung jeweils eine Lichtquelle 3.1 bis 3.N, eine Modulelektronik 20.1 bis 20.N sowie eine Optik, in dem hier dargestellten Ausführungsbeispiel eine Primäroptik 7.1 bis 7.N. Die Modulelektroniken 20.1 bis 20.N der einzelnen Leuchtmodule 1.1 bis 1.N sind über eine serielle Schnittstelle 14 mit dem externen Controller 10 zur Ansteuerung und automatischen Steuerung der N Leuchtmodule 1.1 bis 1.N verbunden, der mehrere analoge und digitale Ein- und Ausgänge und einen Mikroprozessor 11 mit einem eigenen, nicht flüchtigen Speicher 12 aufweist.

Der externe Controller 10 empfängt Daten und Steuerbefehle über eine Steuerleitung 15 und gibt entsprechende Farbsteuersignale an die Leuchtmodule 1.1 bis 1.N ab. Dabei wird eine automatische Temperaturkompensation mit Hilfe von in dem nicht flüchtigen Speicher 12 gespeicherten Kennlinien durchgeführt, so dass die Farbe und Helligkeit der Leuchtmodule 1.1 bis 1.N konstant bleibt. Zu diesem Zweck werden auch die von den auf den Lichtquellen 3.1 bis 3.N angeordneten Temperatursensoren abgegebenen Temperaturwerte eingelesen und durch den externen Controller 10 verarbeitet. Zur Überwachung und gegebenenfalls zum Ausgleich von Langzeiteffekten kann außerdem ein zusätzlicher Fotosensor 13 in den externen Controller 10 integriert werden.

Fig. 18 zeigt eine isometrische Ansicht auf ein LED-Panel, das einen rechteckförmigen Gehäuserahmen 11 mit geschlossener, als Kühlkörperfläche 110 mit Kühlrippen 113 ausgebildeter Unterseite aufweist, in den die die Leuchtmodule 1 aufnehmende Platine 18 gemäß den Fig. 14 bis 16 eingesetzt ist. Das LED-Panel weist an seinen Schmalseiten Eingang-Steckverbinder 115 sowie Ausgangs-Steckverbinder 116 zur Verbindung mit einer Stromversorgungs- und Steuereinrichtung mit einem externen Controller bzw. zur Verbindung mit einem dem jeweiligen LED-Panel zugeordneten dezentralen Steuerelement und/oder einen Akkumulator zur autonomen Energieversorgung des LED-Panels auf.

In die Platine 18 sind acht identisch ausgebildete Leuchtmodule 1 eingesetzt und mechanisch und elektrisch mit der Platine 18 verbunden. Zwischen den in zwei Reihen und acht Spalten angeordneten Leuchtmodulen 1 sind drei Befestigungsmagnete 19 angeordnet, die zur Befestigung einer auf den Gehäuserahmen 11 aufsetzbaren optischen Einrichtung beispielsweise in Form einer Soft-Optik oder Spot-Optik dienen.

In die die Unterseite des Gehäuserahmens 11 bildende Kühlkörperfläche 110 sind drei Aufnahmen 111, 112, 114 integriert, in die ein Verbindungselement einsetzbar und formschlüssig mit dem LED-Panel verbindbar ist. Als Verbindungselement dient insbesondere ein mit einem Stativ, einem Rig oder einem anderem Trägerelement verbundener oder verbindbarer Verbindungszapfen. Die Aufnahmen 111, 112, 114 sind T-förmig nach Art eines geschlitzten Kastenprofils mit und ohne zusätzlicher Nut ausgebildet, während der Verbindungszapfen ein entsprechendes Gegenprofil aufweist, das durch Aufstecken des Verbindungszapfens von der Seite des Gehäuserahmens 11 in die Aufnahmen 111, 112, 114 einsetzbar ist und formschlüssig in Vertiefungen einrastet.

Durch die autarke Ausbildung der Modulelektronik und damit der Leuchtmodule können die Leuchtmodule einzeln angesteuert werden, wodurch unter anderem
- eine dynamische Farbveränderung über die Zeit und über die Leuchtfläche von Modul zu Modul und/oder
- eine dynamische Helligkeitsveränderung bis hin zum kompletten An- oder Abschalten bestimmter Bereiche der Leuchttläche
erreicht wird.

Damit können folgende Effekte erzielt werden:
- durch Einschalten eines Teilbereichs der Leuchtfläche kann die Richtung, aus der das Licht abgestrahlt wird, beispielsweise für eine Portraitbeleuchtung verändert werden;
- die Charakteristik der Beleuchtungseinrichtung kann zwischen "Spotlight" und "Softlight" stufenlos verändert werden, indem beispielsweise wenige Module in der Mitte der Beleuchtungseinrichtung mit hoher Leistung (Spotlight) oder viele Module mit geringer Leistung (Softlight) betrieben werden. Im Rahmen einer elektrischen und thermischen Gesamtleistung sind somit viele Möglichkeiten gegeben;
- es können gezielt Farbsäume erzeugt werden,
- bei einer Sekundäroptik mit kleinem Streuwinkel können Muster auf eine Fläche projiziert und dynamisch in der Farbe und Helligkeit verändert werden.

An mit den Leuchtmodulen 1.1 bis 1.N verbundenen Primäroptiken 7.1 bis 7.N können sich als bewegliche Teile Lichtkupplungen anschließen, die aus einem Lichtleiter oder einem Spiegel- bzw. einem Prismensystem zur Lichtauskopplung bestehen. Alternativ oder zusätzlich können einzelne, jeder Primäroptik 7.1 bis 7.N zugeordnete Sekundäroptiken oder allen Primäroptiken 7.1 bis 7.N gemeinsam eine Sekundäroptik zur Strahlformung vorgesehen werden, die gegebenenfalls motorisch, pneumatisch oder hydraulisch fokussierbar ist bzw. sind.

Je nach Einsatzzweck können dem entsprechend verschiedene Primär- und/oder eingesetzt werden, nämlich
- eine als Whitebox, Hohl- oder Volllichtleiterbox ausgebildete Sekundäroptik mit breitem Streuwinkel, hoher Effizienz und homogener Leuchtfläche;
- eine Projektionsoptik mit engem Streuwinkel;
- eine Spot-Optik mit homogener Ausleuchtung, engem Halbstreuwinkel und hoher Effizienz oder
- eine Soft-Optik mit homogener Ausleuchtung, großem Halbstreuwinkel und hoher Effizienz.

Eine Sekundäroptik zur Strahlformung dient zur variablen Aufweitung des von den Primäroptiken 7.1 bis 7.N bzw. den Lichtquellen 3.1 bis 3.N abgegebenen Lichts auf größere oder kleinere Halbstreuwinkel, wobei die von den Primäroptiken 7.1 bis 7.N bzw. den Lichtquellen 3.1 bis 3.N abgegebenen Lichtstrahlen durch eine entsprechende Linsenanordnung eng und beliebig breit machbar sind, so dass die Fokussierung individuell einstellbar ist.

Schließlich kann sich an die Sekundäroptik optisches Zubehör in Form einer Tertiäroptik zur Veränderung des Abstrahlwinkels, beispielsweise durch gegeneinander verschiebbare Linsenplatten, oder eine Blendeneinrichtung in Form von Flügeltoren zur seitlichen Begrenzung des von der Beleuchtungseinrichtung abgestrahlten Lichts, oder in Form von Irisblenden, Scrims, Gobos und dergleichen anschließen.

Aufgrund des modularen Aufbaus der Beleuchtungseinrichtung sind verschiedene Kombinationen von Leuchtmodulen möglich, die entweder als Basis-Leuchtmodule in Verbindung mit einer Primäroptik ausgestattet sind, wobei eine vorgegebene Anzahl von derartigen Basis-Leuchtmodulen mit Primäroptik zu einer Beleuchtungseinrichtung zusammengefasst sind, die gegebenenfalls mit einer Lichtkupplung, einer Sekundäroptik oder mit optischem Zubehör erweitert wird. So können beispielsweise mehrere Leuchtmodule zu Scheinwerfern oder Flächenleuchten zusammengefasst werden, die über Schnellverbindungen mechanisch und elektrisch aneinander gekoppelt werden, wobei die Licht abstrahlende Fläche des Scheinwerfers oder der Flächenleuchte beliebig gestaltet sein kann, um beispielsweise kreisförmige, quadratische oder längliche Abstrahlflächen zu ermöglichen.

Weitere Ausgestaltungen der erfindungsgemäßen modularen Beleuchtungseinrichtung bestehen darin, dass modular aneinander gereihte Leuchtmodule Gelenke an bestimmten Punkten aufweisen, so dass entweder ein kompaktes Panel mit einer beliebigen geometrischen Form der Licht abgebenden Fläche gebildet wird, das kreisförmig, quadratisch, rechteckig oder als Leuchtstreifen ausgebildet ist, bei dem mehrere Leuchtmodule in einer Reihe hintereinander geschaltet sind.

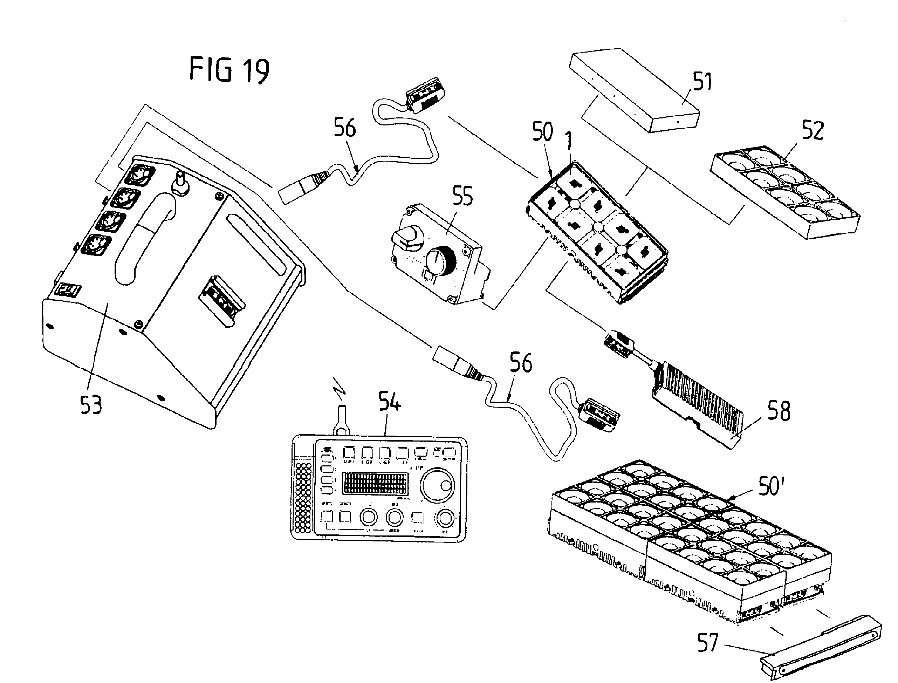

Fig. 19 zeigt ein Übersichtsdiagramm der einzelnen Funktionselemente eines modularen Beleuchtungssystems mit einem einzelnen LED-Panel 50, in dem acht Leuchtmodule 1 mit einer aus Licht unterschiedlicher Wellenlänge und damit Farbe abgebenden LEDs zusammengesetzten Lichtquelle angeordnet sind. Das LED-Panel 50 bildet einen Leuchtkörper, der zusätzlich durch eine auf die Oberseite des LED-Panels 50 aufsetzbare Soft-Optik 61 oder Spot-Optik 52 für eine zusätzlich Lichtmischung des von den Licht unterschiedlicher Wellenlänge und damit Farbe abgebenden LEDs und eine gewünschte Strahlformung erweiterbar ist. Die LED-Panels 50 weisen seitliche elektromechanische Steckverbinder auf, über die mehrere LED-Panels 50 elektrisch und mechanisch zu einer LED-Panelreihe verbunden werden können. Über zusätzliche Querverbinder 57 können mehrere LED-Panelreihen zu einer LED-Panel-Gruppe 50' mit matrixförmiger Struktur zusammengefügt werden.

An ein einzelnes LED-Panel 50 bzw. an eine LED-Panel-Gruppe 50' ist ein einzelnes Steuerelement 55 zur dezentralen Ansteuerung des betreffenden LED-Panels 50 bzw. eine LED-Panel-Gruppe 50' ansteckbar und ermöglicht eine individuelle Ansteuerung oder Einstellung von Lichtparametern der Leuchtmodule des betreffenden LED-Panels 50 oder der LED-Panel-Gruppe 50'. Das Steuerelement 55 kann nach der Eingabe von Daten bzw. Einstellung der Parameter wieder von dem LED-Panel 50 getrennt werden..

Zur autonomen Stromversorgung kann ein einzelnes LED-Panel 50 oder eine mit dem LED-Panel 50 elektrisch und mechanisch verbundene LED-Panel-Gruppe 50' mit einem Akkumulator 58 verbunden werden, der vorzugsweise ebenfalls unmittelbar oder über ein Verbindungselement an das LED-Panel 50 ansteckbar ist.

Eine zentrale Leistungssteuereinheit 53, 54 dient zur Stromversorgung eines LED-Panels 50 bzw. einer LED-Panel-Gruppe 50' sowie zur Eingabe von Sollwerten zur Ansteuerung der Leuchtmodule 1 der einzelnen LED-Panels 50 und besteht aus einer Stromversorgungs- und Andockstation 53 und einem Steuergerät 54, das an die Stromversorgungs- und Andockstation 53 angesteckt oder über eine Funk- oder Leitungsverbindung getrennt von der Stromversorgungs- und Andockstation 53 bedient werden kann. Die Stromversorgungs- und Andockstation 53 weist mehrere Buchsen auf, die über Anschlusskabel 56 eine elektrische Verbindung zur Stromversorgung und Ansteuerung des LED-Panels 50 bzw. der LED-Panel-Gruppe 50' herstellt.

### Bezugszeichenliste

- 1: Leuchtmodul
- 1.1 - 1.N: Leuchtmodule
- 2: Modulträger
- 3, 3': Lichtquelle
- 3.1 - 3.N: Lichtquellen
- 4: Leuchtdioden (LEDs)
- 5: Ring
- 6: Vergussmasse
- 7: Primäroptik
- 7.1 - 7.N: Primäroptiken
- 8: Sekundäroptik
- 9: Tertiäroptik
- 10: externer Controller
- 11: Gehäuserahmen
- 12: Speicher
- 13: Fotosensor
- 14: serielle Schnittstelle
- 15: Steuerleitung
- 16: Modul-Kühlkörper
- 18: Platine (Motherboard, Backplane)
- 19: Besfestigungsmagnete
- 20: Modulelektronik
- 20.1 - 20.N: Modulelektroniken
- 21: Aussparung
- 22: Kontaktstecker
- 23: Kontaktleiste
- 24 - 26: Befestigungsaufnahmen
- 30: Platine
- 31: Kontakt (Lötfahnen)
- 32, 33: Bohrungen
- 34: Temperatursensor
- 34.1, 34.2: Kontakte
- 35: Leiterbahnen
- 36: Helligkeits- und/oder Farbsensor
- 37, 38: Verstärker
- 50: LED-Panel
- 51: Soft-Optik
- 52: Spot-Optik
- 53: Stromversorgungs- und Andockstation
- 54: Steuergerät
- 55: Steuerelement
- 56: Anschlusskabel
- 57: Querverbinder
- 58: Akkumulator
- 68: Elektronischer Schalter
- 69: Widerstand
- 71: Einrichtung zur Lichtbündelung
- 72: Lichtmischeinrichtung
- 73: Farbmischeinrichtung
- 81,82: Mikrolinsenplatten
- 91: Flügeltor
- 92: Diffuser
- 93: Scrims
- 110: Kühlkörperfläche
- 111,112,114: Aufnahmen
- 115, 116, 117: Eingangs- und Ausgangs-Steckverbinder
- 161: Sockel
- 162: Gewindebohrung
- 171: Schrauben
- 172: Kerbnägel
- 181: Öffnungen
- 182: Steckbuchsen
- 201 - 206: Ansteuerstufen
- 220: Kontakte
- 300: Metallkernplatine
- 401 - 404: weißes Licht abgebende LEDs
- 405 - 410: warmweißes Licht abgebende LEDs
- 411 - 413: rotes Licht abgebender LEDs
- 421 - 423: grünes Licht abgebender LEDs
- 431 - 434: blaues Licht abgebende LEDs
- 441 - 443: gelbes oder amberfarbenes Licht abgebende LEDs
- 401.1 - 442.2: Elektrische Kontakte (Kontaktflächen)
- AIN1,2: Microcontroller-Eingänge
- GND: Massepotential
- SER A/B: serielle Schnittstellen
- U_{LED1}-U_{LED6}: Versorgungsspannungen
- V_{LED1}, V_{LED2}: Versorgungsspannungen
- PWM1-PWM6: Prozessor-Ausgänge

## Patentansprüche

1. Beleuchtungseinrichtung mit mehreren Leuchtmodulen (1; 1.1 bis 1.N), die einen Modulträger (2; 2.1 bis 2.N) aufweisen, auf dem eine Lichtquelle (3, 3') mit mehreren, auf einer Platine (30) angeordneten, Licht unterschiedlicher Wellenlänge abgebenden steuerbaren Leuchtdioden (LEDs 4; 401 bis 443), ein Temperatursensor (34) und eine Modulelektronik (20; 20.1 bis 20.N) angeordnet sind,
**dadurch gekennzeichnet,**
- **dass** die Modulelektronik (20; 20.1 bis 20.N) eine digitale Schaltung mit einem Microcontroller (60) zur lokalen und autarken Signalverarbeitung enthält, der die LEDs (4; 401 - 443) in Abhängigkeit von der Temperatur derart ansteuert, dass die aus den Licht unterschiedlicher Wellenlänge abgebenden LEDs (4; 401 - 443) zusammengesetzte Helligkeit, Farbe und Farbart der Lichtmischung konstant ist,
- **dass** die Leuchtmodule (1; 1.1 bis 1.N) über eine digitale Schnittstelle mit anderen Leuchtmodulen (1; 1.1 bis 1.N) und/oder einem externen Controller (10) zur Übertragung der mittels des Temperatursensors (34) erfassten Board-Temperatur (T_{Board}) des betreffenden Leuchtmoduls (1; 1.1 bis 1.N) verbunden sind.
- und **dass** ein zentrales Master-Modul oder der externe Controller (10) die Leuchtmodule (1; 1.1 bis 1.N) so ansteuert, dass eine gleichmäßige Helligkeit über die Abstrahlfläche entsteht.

2. Beleuchtungseinrichtung nach Anspruch 1, **dadurch gekennzeichnet, dass** der externe Controller (10) eine periodische Abfrage aller Platinentemperaturen (T_{Board}) der Leuchtmodule (1; 1.1 bis 1.N) durchführt und ein die höchste ermittelte Temperatur (Tₘₐₓ) repräsentierendes Signal an alle Leuchtmodule (1; 1.1 bis 1.N) abgibt, die nach einem Synchronisationsbefehl eine Helligkeitsanpassung auf der Grundlage des der höchsten ermittelten Temperatur (Tₘₐₓ) repräsentierenden Signals durchführen.

3. Beleuchtungseinrichtung nach Anspruch 1 oder 2, **dadurch gekennzeichnet, dass** die Leuchtmodule (1; 1.1 bis 1.N) über eine digitale, serielle Schnittstelle (SER A/B) mit dem externen Controller (10) zur Übertragung von Daten zur Ansteuerung der Farbkanäle mittels vom externen Controller (10) an die Leuchtmodule (1; 1.1 bis 1.N) abgegebener Farbsteuersignale, Kalibrierung und Abfragen von Statusinformationen der Leuchtmodule (1; 1.1 bis 1.N) und zum Download des Betriebsprogramms verbunden sind.

4. Beleuchtungseinrichtung nach mindestens einem der vorangehenden Ansprüche, **dadurch gekennzeichnet, dass** die Leuchtmodule (1; 1.1 bis 1.N) und eine übergeordnete Steuer- und Regeleinrichtung (10) derart programmierbar sind, dass
- in einem bezüglich der Farbwiedergabe optimierten Betriebsmodus weißes Licht mit sehr guter Farbwiedergabe für Beleuchtungszwecke oder
- in einem bezüglich der Helligkeit optimierten Betriebsmodus vorwiegend farbiges Licht mit großer Lichtstärke für Zwecke der Studio, Theater- und Effektbeleuchtung
abgestrahlt wird.

5. Beleuchtungseinrichtung nach mindestens einem der vorangehenden Ansprüche, **dadurch gekennzeichnet, dass** mehrere Leuchtmodule (1; 1.1 bis 1.N) und der externe Controller (10) auf einem LED-Panel oder Motherboard (18) angeordnet sind, wobei mehrere Leuchtmodule (1.1 bis 1.N) vorzugsweise in Öffnungen (181. 182) des Motherboards (18) einsetzbar sind.

6. Beleuchtungseinrichtung nach mindestens einem der vorangehenden Ansprüche, **dadurch gekennzeichnet, dass** die Platine (30) der Lichtquelle (3, 3') auf einem gegenüber einer Oberfläche des Modul-Kühlkörpers (16) erhöhten Sockel (161) des Modul-Kühlkörpers (16) angeordnet ist und dass die den Sockel (161) aufnehmende Oberfläche des Modul-Kühlkörpers (16) Befestigungselemente (171, 172) zur Verbindung des Modul-Kühlkörpers (16) mit dem Modulträger (2) aufweist.

7. Beleuchtungseinrichtung nach mindestens einem der vorangehenden Ansprüche, **dadurch gekennzeichnet, dass** der Modulträger (2) plattenförmig ausgebildet ist und eine Ausnehmung zum Einsetzen der als Leiterplatte ausgebildeten Platine (30) oder des Sockels (161) des Modul-Kühlkörpers (16) sowie (2) Befestigungsaufnahmen für die Platine (30) und/oder den Modul-Kühlkörper (16) und/oder Verbindungselemente zum Verbinden des Modulträgers (2) mit dem Motherboard (18) aufweist.

8. Beleuchtungseinrichtung nach mindestens einem der vorangehenden Ansprüche, **dadurch gekennzeichnet, dass** der Modulträger (2) einen Umriss für eine im Wesentlichen lückenlose Aneinanderreihung einer Vielzahl gleichartig ausgebildeter Leuchtmodule (1) für eine Licht abgebende Fläche eines Beleuchtungsgerätes aufweist.

9. Beleuchtungseinrichtung nach mindestens einem der vorangehenden Ansprüche, **dadurch gekennzeichnet, dass** die Modulelektronik (20) mit mindestens einem auf dem Modulträger (2) angeordneten Helligkeits- und/oder Farbsensor (36), verbunden ist.

10. Beleuchtungseinrichtung nach mindestens einem der vorangehenden Ansprüche, **dadurch gekennzeichnet, dass** zur Überwachung oder zum Ausgleich von Langzeiteffekten ein Fotosensor (13) in den externen Controller (10) integriert ist.

11. Beleuchtungseinrichtung nach mindestens einem der vorangehenden Ansprüche, **dadurch gekennzeichnet, dass** die Modulelektronik (20; 20.1 bis 20.N) pulsweitenmodulierte Steuersignale zur Ansteuerung der LEDs (4; 401 - 442) der Lichtquelle (3, 3') abgibt und auf jedem Farbkanal Signale oder Werte bezüglich der Helligkeit des von den LEDs (4; 401 - 442) abgegebenen weißen bzw. farbigen Lichts unter Vorgabe eines Strom-Sollwertes (I_{SOLL})von der seriellen Schnittstelle (SER A/B),
- der Grundhelligkeit durch eine unkorrigierte Helligkeit des Farbkanals bei Nennbedingungen,
- der Temperatur durch das von dem Temperatursensor (34) der Lichtquelle (3, 3') abgegebene Temperatursignal (T_{Board}),
- einer Kennliniensteuerung für die Temperaturkompensation der Helligkeit und
- der höchsten Temperatur (Tₘₐₓ) in der Beleuchtungseinrichtung bzw. dem Leuchtmodul (1; 1.1 bis 1.N) zur Kompensation von konvektionsbedingten Helligkeitsunterschieden
verarbeitet.

12. Beleuchtungseinrichtung nach mindestens einem der vorangehenden Ansprüche, **dadurch gekennzeichnet, dass** die Modulelektronik (20) die Licht unterschiedlicher Wellenlänge abgebenden LEDs (4; 401 bis 443) individuell oder in Gruppen von jeweils Licht gleicher Wellenlänge abgebenden LEDs (4; 401 bis 443) ansteuert.

13. Beleuchtungseinrichtung nach mindestens einem der vorangehenden Ansprüche, **dadurch gekennzeichnet, dass** die Modulelektronik (20) über eine serielle Schnittstelle (SER A, SER B) mit dem externen Controller (10) und über mindestens eine Stromversorgungsleitung mit einer Spannungsquelle (U_{LED1} - U_{LED6}) verbunden ist.

14. Beleuchtungseinrichtung nach mindestens einem der vorangehenden Ansprüche, **dadurch gekennzeichnet, dass** die Modulelektronik (20) eine Schaltung (67, 68, 69) zur Stromversorgung, Strombegrenzung und/oder zur Stromregelung der Licht unterschiedlicher Wellenlänge abgebenden LEDs (4; 401 - 443) aufweist.

15. Beleuchtungseinrichtung nach mindestens einem der vorangehenden Ansprüche, **dadurch gekennzeichnet, dass** die Modulelektronik (20) mehrere gleichartig aufgebaute Treiberschaltungen (61 bis 66) zur Ansteuerung einzelner LEDs (4; 401 bis 443) oder zur gleichzeitigen Ansteuerung mehrerer, jeweils Licht gleicher Wellenlänge abgebender LEDs (4; 401 bis 443) enthält und dass die Treiberschaltungen (61 bis 66) an jeweils einen pulsweitenmodulierte Steuersignale abgebenden Ausgang (PWM1 - PWM6) des Mikrocontrollers (6) angeschlossen und mit einer für jeden Ausgang individuellen oder für bestimmte Gruppen von Ausgängen gemeinsamen Versorgungsspannung (U_{LED1} - U_{LED6}) beaufschlagt sind.

16. Beleuchtungseinrichtung nach Anspruch 15, **dadurch gekennzeichnet, dass** die Treiberschaltungen (61 bis 66) eine temperaturkompensierte Konstantstromquelle (67) aufweisen, die an eine der Treiberschaltung (61 bis 66) zugeordnete Versorgungsspannung (U_{LED1} - U_{LED6}) angeschlossen ist und einen in Reihe zu den von der jeweiligen Treiberschaltung (61 bis 66) gespeisten LEDs (4; 401 - 443) geschalteten elektronische Schalter (68) derart ansteuert, dass die LEDs (4; 401 - 443) mit einem konstanten Strom (I_{Peak, const}) gespeist werden.

17. Beleuchtungseinrichtung nach mindestens einem der vorangehenden Ansprüche, **dadurch gekennzeichnet, dass** die LEDs (4; 401 - 443) als LED-Chips ausgebildet sind, die in Chip-on-Board-Technologie mit den Leiterbahnen (35) der Platine (30) vorzugsweise durch Bondung, Flip-chip-Kontaktierung oder Leitklebung elektrisch kontaktiert sind.

18. Beleuchtungseinrichtung nach mindestens einem der vorangehenden Ansprüche, **gekennzeichnet durch** eine an das Leuchtmodul (1) und/oder an mehrere zu einer Leuchtmodulgruppe zusammengefasste Leuchtmodule (1.1 bis 1.N) angekoppelte Optik.

19. Beleuchtungseinrichtung nach Anspruch 18, **dadurch gekennzeichnet, dass** die Optik zwei gegeneinander verstellbare Mikrolinsenplatten (81, 82) zum Aufweiten oder Zusammenfassen der von den LEDs (4; 401 - 443) abgegebenen Lichtstrahlen aufweist.

20. Beleuchtungseinrichtung nach Ansprüche 18 oder 19, **dadurch gekennzeichnet, dass** eine Sekundäroptik (8) zur Fokussierung der von der Lichtquelle (3) abgegebenen Lichtstrahlen bzw. zur Veränderung des Halbstreuwinkels insbesondere in Richtung der optischen Achse des Leuchtmoduls (1) motorisch, pneumatisch oder hydraulisch verstellbar ist.

21. Beleuchtungseinrichtung nach mindestens einem der vorangehenden Ansprüche, **dadurch gekennzeichnet, dass** die Lichtquelle (3, 3') und/oder eine Primäroptik (7) zum Sammeln der von den LEDs (4; 401 - 443) abgegebenen Lichtstrahlen und/oder die Sekundäroptik (8) mit einer Einrichtung zur Lichtauskopplung, insbesondere mit einem Lichtleiter oder mit einem Spiegel- oder Prismensystem, verbunden ist bzw. sind.

## Claims

1. A lighting device comprising a plurality of lighting modules (1; 1.1 to 1.N) which include a module carrier (2; 2.1 to 2.N) on which a light source (3, 3') with a plurality of controllable light-emitting diodes (LEDs 4; 401 to 443) emitting light of different wavelengths and arranged on a board (30), a temperature sensor (34) and a module electronic (20; 20.1 to 20.N) are arranged,
**characterized in**
- **that** the module electronic (20; 20.1 to 20.N) contains a digital circuit with a microcontroller (60) for the local and autonomous signal processing, which actuates the LEDs (4; 401 - 443) in dependence on the temperature such that the brightness, color and chrominance of the light mixture composed of the LEDs (4; 401 - 443) emitting light of different wavelengths is constant,
- **that** via a digital interface the lighting modules (1; 1.1 to 1.N) are connected with other lighting modules (1; 1.1 to 1.N) and/or an external controller (10) for transmitting the board temperature (T_{Board}) of the respective lighting module (1; 1.1 to 1.N) detected by means of the temperature sensor (34),
- and **that** a central master module or the external controller (10) actuates the lighting modules (1; 1.1 to 1.N) such that a uniform brightness is obtained over the radiating surface.

2. The lighting device according to claim 1, **characterized in that** the external controller (10) performs a periodic scan of all board temperatures (T_{Board}) of the lighting modules (1; 1.1 to 1.N) and issues a signal representing the highest temperature (Tₘₐₓ) determined to all lighting modules (1; 1.1 to 1.N), which after a synchronization command perform a brightness adaptation on the basis of the signal representing the highest temperature (Tₘₐₓ) determined.

3. The lighting device according to claim 1 or 2, **characterized in that** via a digital, serial interface (SER A/B) the lighting modules (1; 1.1 to 1.N) are connected with the external controller (10) for the transmission of data for actuating the color channels by means of color control signals issued by the external controller (10) to the lighting modules (1; 1.1 to 1.N) , calibration and retrieval of status information of the lighting modules (1; 1.1 to 1.N) and for the download of the operating program.

4. The lighting device according to one at least of the preceding claims, **characterized in that** the lighting modules (1; 1.1 to 1.N) and a superordinate control and regulating means (10) are programmable such that
- in an operating mode optimized in terms of color rendering white light with very good color rendering for lighting purposes, or
- in an operating mode optimized in terms of brightness chiefly colored light with great luminous intensity for the purpose of studio, theatre and effect lighting is radiated.

5. The lighting device according to at least one of the preceding claims, **characterized in that** a plurality of lighting modules (1; 1.1 to 1.N) and the external controller (10) are arranged on an LED panel or motherboard (18), wherein a plurality of lighting modules (1.1 to 1.N) can be inserted preferably into openings (181, 182) of the motherboard (18).

6. The lighting device according to at least one of the preceding claims, **characterized in that** the board (30) of the light source (3, 3') is arranged on a base (161) of the module heat sink (16) which is elevated with respect to a surface of the module heat sink (16) and that the surface of the module heat sink (16) accommodating the base (161) includes fastening elements (171, 172) for connecting the module heat sink (16) with the module carrier (2).

7. The lighting device according to at least one of the preceding claims, **characterized in that** the module carrier (2) is plate-shaped and includes a recess for inserting the board (30) formed as circuit board or the base (161) of the module heat sink (16) and mounting holes for the board (30) and/or the module heat sink (16) as well as connecting elements for connecting the module carrier (2) with the motherboard (18).

8. The lighting device according to at least one of the preceding claims, **characterized in that** the module carrier (2) has a contour for a substantially uninterrupted line-up of a multitude of similarly formed lighting modules (1) for a light-emitting surface of a lighting equipment.

9. The lighting device according to at least one of the preceding claims, **characterized in that** the module electronic (20) is connected with at least one brightness and/or color sensor (36) arranged on the module carrier (2).

10. The lighting device according to at least one of the preceding claims, **characterized in that** for monitoring or for compensating long-term effects a photosensor (13) is integrated in the external controller (10).

11. The lighting device according to at least one of the preceding claims, **characterized in that** the module electronic (20; 20.1 to 20.N) issues pulse-width-modulated control signals for actuating the LEDs (4; 401 - 442) of the light source (3; 3') and on each color channel processes signals or values with respect to the brightness of the white or colored light emitted by the LEDs (4; 401 - 442) by specifying a desired current value (I_{DES}) from the serial interface (SER A/B),
- the basic brightness due to an uncorrected brightness of the color channel under nominal conditions,
- the temperature by the temperature signal (T_{Board}) issued by the temperature sensor (34) of the light source (3, 3'),
- a characteristic curve control for the temperature compensation of the brightness, and
- the highest temperature (Tₘₐₓ) in the lighting device or the lighting module (1; 1.1 to 1.N) for compensating convection-related differences in brightness.

12. The lighting device according to at least one of the preceding claims, **characterized in that** the module electronic (20) individually actuates the LEDs (4; 401 to 443) emitting light of different wavelengths or the module electronic (20) actuates groups of LEDs (4; 401 to 443) each emitting light of the same wavelength

13. The lighting device according to at least one of the preceding claims, **characterized in that** the module electronic (20) is connected with the external controller (10) via a serial interface (SER A, SER B) and with a voltage source (U_{LED1} - U_{LED6}) via at least one power supply line.

14. The lighting device according to at least one of the preceding claims, **characterized in that** the module electronic (20) includes a circuit (67, 68, 69) for the power supply, power limitation and/or power control of the LEDs (4; 401 to 443) emitting light of different wavelengths.

15. The lighting device according to at least one of the preceding claims, **characterized in that** the module electronic (20) contains a plurality of similarly constructed drive circuits (61 to 66) for actuating individual LEDs (4; 401 to 443) or for simultaneously actuating a plurality of LEDs (4; 401 to 443) each emitting light of the same wavelength and **in that** the drive circuits (61 to 66) each are connected to an output (PWM1 - PWM6) of the microcontroller (6) emitting pulse-width-modulated control signals and are supplied with a supply voltage (U_{LED1} - U_{LED6}) or a number of n different supply voltages (U_{LED1} - U_{LED6}).

16. The lighting device according to claim 15, **characterized in that** the drive circuits (61 to 66) include a temperature-compensated constant-current source (67) which is connected to a supply voltage (U_{LED1} - U_{LED6}) associated to the drive circuit (61 to 66) and actuates an electronic switch (68) connected in series to the LEDs (4; 401 to 443) fed by the respective drive circuit (61 to 66) such that the LEDs (4; 401 to 443) are fed with a constant current (I_{Peak, const}).

17. The lighting device according to at least one of the preceding claims, **characterized in that** the LEDs (4; 401 to 443) constitute LED chips which in a chip-on-board technology are electrically contacted with the conductors (35) of the board (30), preferably by bonding, flip-chip contacting or conductive gluing.

18. The lighting device according to at least one of the preceding claims, **characterized by** an optic coupled to the lighting module (1) and/or to a plurality of lighting modules (1.1 to 1.N) combined to a group of lighting modules.

19. The lighting device according to claim 18, **characterized in that** the optic (8) includes two microlens plates (81, 82) adjustable with respect to each other for expanding or concentrating the light beams emitted by the LEDs (4; 401 - 443).

20. The lighting device according to claim 18 or 19, **characterized in that** for focusing the light beams emitted by the light source (3) and for varying the half-peak angle in particular in the direction of the optical axis of the lighting module (1) a secondary optic (8) is adjustable by motor, pneumatically or hydraulically.

21. The lighting device according to at least one of the preceding claims, **characterized in that** the light source (3, 3') and/or the primary optic (7) for collecting the light beams emitted by the LEDs (4; 401 - 443) and/or the secondary optic (8) is/are connected with a means for coupling out light, in particular with a light guide or with a mirror or prism system.

## Revendications

1. Système d'éclairage comprenant plusieurs modules d'éclairage (1 ; 1.1 à 1.N), qui comprennent un support de module (2 ; 2.1 à 2.N) sur lequel sont agencés une source de lumière (3, 3') avec plusieurs diodes électroluminescentes (LED 4 ; 401 à 443) commandées, agencées sur une platine (30) et émettant de la lumière avec des longueurs d'onde différentes, un capteur de température (34) et une électronique de module (20 ; 20.1 à 20.N),
**caractérisé en ce que**
- l'électronique de module (20 ; 20.1 à 20.N) contient un circuit numérique avec un microcontrôleur (60) pour un traitement local et autarcique des signaux, qui pilote les diodes électroluminescentes (4 ; 401-443) en fonction de la température de telle façon que la luminosité, la couleur et la nuance du mélange lumineux composé à partir des lumières émises par les diodes électroluminescentes (4 ; 401 à 443) avec des longueurs d'onde différentes sont constantes,
- les modules d'éclairage (1 ; 1.1 à 1.N) sont reliés via une interface numérique à d'autres modules d'éclairage (1 ; 1.1 à 1.N) et/ou à un contrôleur externe (10) pour la transmission de la température de la carte (T_{carte}), détectée au moyen du capteur de température (34), du module d'éclairage concerné (1 ; 1.1 à 1.N),
- un module maître central ou le contrôleur externe (10) pilote les modules d'éclairage (1 ; 1.1 à 1.N) de telle façon qu'il en résulte une luminosité régulière sur la surface d'émission.

2. Système d'éclairage selon la revendication 1,
**caractérisé en ce que** le contrôleur externe (10) exécute une interrogation périodique de toutes les températures des platines (T_{carte}) des modules d'éclairage (1 ; 1.1 à 1.N), et délivre à tous les modules d'éclairage (1; 1.1 à 1.N) un signal qui représente la température déterminée la plus élevée (Tₘₐₓ), lesquels exécutent, après un ordre de synchronisation, une adaptation de luminosité en se basant sur le signal représentant la température déterminée la plus élevée (Tₘₐₓ).

3. Système d'éclairage selon la revendication 1 ou 2,
**caractérisé en ce que** les modules d'éclairage (1 ; 1.1 à 1.N) sont reliés via une interface série numérique (SER A/B) avec le contrôleur externe (10) pour la transmission de données destinées au pilotage des canaux de couleur au moyen de signaux de commande de couleur délivrés par le contrôleur externe (10) aux modules d'éclairage (1 ; 1.1 à 1.N), au calibrage et à l'interrogation des informations d'état des modules d'éclairage (1 ; 1.1 à 1.N), et au téléchargement du programme de service.

4. Système d'éclairage selon l'une au moins des revendications précédentes,
**caractérisé en ce que** les modules d'éclairage (1 ; 1.1 à 1.N) et un système de commande et de régulation maître (10) peuvent être programmés de telle façon que le rayonnement a lieu
- dans un mode de fonctionnement à lumière blanche optimisé vis-à-vis de la restitution en couleurs avec une très bonne restitution en couleurs à des fins d'éclairage, ou
- dans un mode de fonctionnement à lumière essentiellement colorée optimisée vis-à-vis de la luminosité avec une intensité lumineuse élevée à des fins d'éclairage de studio, de théâtre ou d'éclairage à effet.

5. Système d'éclairage selon l'une au moins des revendications précédentes,
**caractérisé en ce que** plusieurs modules d'éclairage (1 ; 1.1 à 1.N) et le contrôleur externe (10) sont agencés sur un panneau à LED ou carte-mère (18), de sorte que plusieurs modules d'éclairage (1 ; 1.1 à 1.N) peuvent être mis en place de préférence dans des ouvertures (181, 182) de la carte-mère (18).

6. Système d'éclairage selon l'une au moins des revendications précédentes,
**caractérisé en ce que** la platine (30) de la source de lumière (3, 3') est agencée sur un socle (161), soulevé par rapport à une surface du corps de refroidissement (16) du module, du corps de refroidissement (16), et **en ce que** la surface, qui reçoit le socle (161), du corps de refroidissement du module (16), comprend des éléments de fixation (171, 172) pour la liaison du corps de refroidissement du module (16) avec le support de module (2).

7. Système d'éclairage selon l'une au moins des revendications précédentes,
**caractérisé en ce que** le support de module (2) est réalisé en forme de plaque et comporte un évidement pour la mise en place de la platine (30), réalisé sous forme de carte à circuits imprimés, ou du socle (161) du corps de refroidissement (16) du module ainsi que des récepteurs de fixation pour la platine (30) et/ou pour le corps de refroidissement (16) du module et/ou des éléments de liaison pour la liaison du support de module (2) avec la carte-mère (18).

8. Système d'éclairage selon l'une au moins des revendications précédentes,
**caractérisé en ce que** le support de module (2) présente un contour permettant de disposer une pluralité de modules d'éclairage (1) de réalisation similaire en formant une rangée essentiellement sans lacunes, pour une surface d'un appareil d'éclairage délivrant de la lumière.

9. Système d'éclairage selon l'une au moins des revendications précédentes,
**caractérisé en ce que** l'électronique de module (20) est reliée à au moins un capteur de luminosité et/ou capteur de couleurs (36) agencé sur le support de module (2).

10. Système d'éclairage selon l'une au moins des revendications précédentes,
**caractérisé en ce qu'**un capteur photosensible (13) est intégré dans le contrôleur externe (10) pour la surveillance ou pour la compensation d'effets à long terme.

11. Système d'éclairage selon l'une au moins des revendications précédentes,
**caractérisé en ce que** l'électronique de module (20 ; 20.1 à 20.N) délivre des signaux de commande modulés en largeur d'impulsion pour le pilotage des LED (4 ; 401-442) de la source de lumière (3, 3') et traite sur chaque canal de couleur des signaux ou des valeurs vis-à-vis de la luminosité de la lumière, blanche ou colorée, délivré(e)s par les LED (4 ; 401-442) en imposant une valeur de consigne de courant (I_{consigne}) de la part de l'interface série (SER A/B),
- de la luminosité de base par une luminosité non corrigée du canal de couleur pour des conditions nominales,
- de la température au moyen du signal de température (T_{carte}) délivré par le capteur de température (34) de la source de lumière (3, 3'),
- d'une commande à courbe caractéristique pour la compensation de température de la luminosité, et
- de la température la plus élevée (Tₘₐₓ) dans le système d'éclairage ou dans le module d'éclairage (1 ; 1.1 à 1.N), pour la compensation de différences de luminosité dues à la convection.

12. Système d'éclairage selon l'une au moins des revendications précédentes,
**caractérisé en ce que** l'électronique de module (20) pilote les LED (4 ; 401-443) qui délivrent de la lumière à des longueurs d'onde différentes individuellement ou par groupe de LED (4 ; 401-443) délivrant respectivement de la lumière à des longueurs d'onde égales.

13. Système d'éclairage selon l'une au moins des revendications précédentes,
**caractérisé en ce que** l'électronique de module (20) est reliée via une interface série (SER A, SER B) au contrôleur externe (10) et via au moins une ligne d'alimentation électrique à une source de tension (U_{LED1}-U_{LED6}).

14. Système d'éclairage selon l'une au moins des revendications précédentes,
**caractérisé en ce que** l'électronique de module (20) comprend un circuit (67, 68, 69) pour l'alimentation électrique, pour la limitation de courant et/ou pour la régulation du courant pour les LED (4 ; 401-443) fournissant de la lumière à des longueurs d'onde différentes.

15. Système d'éclairage selon l'une au moins des revendications précédentes,
**caractérisé en ce que** l'électronique de module (20) contient plusieurs circuits pilotes (61 à 66) réalisés de la même manière pour le pilotage de LED (4 ; 401-443) individuelles ou pour le pilotage simultané de plusieurs LED (4 ; 401-443) délivrant respectivement de la lumière à la même longueur d'onde, et **en ce que** les circuits pilotes (61 à 66) sont raccordés respectivement à une sortie (PWM1-PWM6), du microcontrôleur (6), délivrant respectivement des signaux de commande modulés en largeur d'impulsion, et sont alimentés avec une tension d'alimentation commune (U_{LED1}-U_{LED6}) individuellement pour chaque sortie ou pour certains groupes de sorties.

16. Système d'éclairage selon la revendication 15,
**caractérisé en ce que** les circuits pilotes (61 à 66) comprennent une source de de courant constante (67) compensée en température, qui est raccordée à une tension d'alimentation (U_{LED1}-U_{LED6}) et qui pilote un commutateur électronique (68) branché en série par rapport aux LED (4 ; 401-443) alimentées par le circuit pilote respectif (61 à 66) de telle façon que les LED (4 ; 401-443) sont alimentées avec un courant constant (Ipeak, const).

17. Système d'éclairage selon l'une au moins des revendications précédentes,
**caractérisé en ce que** les LED (4 ; 401-443) sont réalisées sous forme de puces à LED, qui sont amenées en contact électrique suivant une technologie dite "chip-on-board" avec les pistes conductrices (35) de la platine (30) de préférence par bonding, par technologie "flip-chip" ou par collage conducteur.

18. Système d'éclairage selon l'une au moins des revendications précédentes,
**caractérisé par** une optique couplée au module d'éclairage (1) ou et/ou à plusieurs modules d'éclairage (1.1 à 1.N) regroupés pour former un groupe de modules d'éclairage.

19. Système d'éclairage selon la revendication 18,
**caractérisé en ce que** l'optique comprend deux plaque à microlentilles (81, 82) déplaçables l'une par rapport à l'autre pour élargir ou pour contracter les rayons lumineux délivrés par les LED (4 ; 401-443).

20. Système d'éclairage selon les revendications 18 ou 19,
**caractérisé en ce qu'**il est prévu une optique secondaire (8) réglable de façon motorisée, pneumatique ou hydraulique, pour la focalisation des rayons lumineux délivrés par la source de lumière (3), ou respectivement pour modifier le demi-angle de diffusion, en particulier en direction de l'axe optique du module d'éclairage (1).

21. Système d'éclairage selon l'une au moins des revendications précédentes,
**caractérisé en ce que** la source de lumière (3, 3') et/ou une optique primaire (7) pour collecter les rayons lumineux délivrés par les LED (4 ; 401-443) et/ou l'optique secondaire (8) est/sont reliée(s) à un système de découplage de lumière, en particulier à un conducteur de lumière ou à un système à miroirs ou à prisme.
